# EUROPÄISCHE PATENTSCHRIFT

(11) **EP 4 187 569 B1**
(45) Veröffentlichungstag und Bekanntmachung des Hinweises auf die Patenterteilung: **07.01.2026**
(21) Anmeldenummer: 21210624.9
(22) Anmeldetag: 25.11.2021
(51) Int. Cl.: H01H 47/00, H01H 9/16, H03K 17/687

(54) **LABORZENTRIFUGE MIT ENTFLAMMBAREM KÄLTEMITTEL**
LABORATORY CENTRIFUGE WITH FLAMMABLE REFRIGERANT
CENTRIFUGEUSE DE LABORATOIRE COMPRENANT UN RÉFRIGÉRANT INFLAMMABLE

(43) Veröffentlichungstag der Anmeldung: 31.05.2023
(73) Patentinhaber: Eppendorf SE, 22339 Hamburg (DE)
(72) Erfinder: Beukert, Uwe, 22339 Hamburg (DE); Binder, Falk, 22339 Hamburg (DE)
(74) Vertreter: Hecht, Jan-David

(56) Entgegenhaltungen:
- EP-A2- 2 632 009
- DE-A1- 2 410 720
- JP-A- 2013 219 955
- US-A1- 2019 204 388
- US-A1- 2020 326 374

## Beschreibung

Die Erfindung betrifft eine Laborzentrifuge mit entflammbarem Kältemittel sowie ein Verfahren zum Betreiben und ein Verfahren zur Herstellung einer solchen Laborzentrifuge.

Gekühlte Laborzentrifugen haben verschiedenen sicherheitstechnischen Anforderungen genügen. In der Norm DIN EN 61010-2-011 werden beispielsweise Sicherheitsbestimmungen für elektrische Mess-, Steuer-, Regel- und Laborgeräte vorgegeben. Es soll insbesondere sichergestellt werden, dass der Entwurf und der Aufbau von Kühlgeräten einen ausreichenden Schutz vor bestimmten Gefährdungen für Benutzer, Nebenstehende, geschultes Service-Personal und die umgebenden Flächen vor den speziellen Gefährdungen, die von gekühlten Systemen ausgehen können, bietet.

In der Norm DIN EN 378 wird der Lebenszyklus von Kälteanlagen betrachtet, insbesondere in Bezug auf die Anlagen-/Gerätesicherheit, aber auch zum Beispiel in Bezug auf Aufstellungsbereiche der Anlagen, Grenzwerte von Kältemitteln oder den Schutz von Personen in Kühlräumen. In der Norm werden insbesondere die Brennbarkeitsklassen 1 (keine Flammenausbreitung), 2L (gering brennbar), 2 (brennbar), 3 (hoch brennbar) für Kältemittel thematisiert, die in der Norm ISO 817 definiert werden. Beispiele für Kältemittel sind z. B.: Propan, (Iso-)Butan (Brennbarkeitsklasse 3); R152a (Brennbarkeitsklasse 2); R1234yf (Brennbarkeitsklasse 2L); R410A, R22 (Brennbarkeitsklasse 1). In dieser Beschreibung werden die Begriffe Brennbarkeit und Entflammbarkeit synonym verwendet.

Hoch brennbare Kohlenwasserstoffe, insbesondere Propan und (Iso-)Butan weisen günstige Umwelteigenschaften auf. So liegt beispielsweise der Wert des Ozonabbaupotentials ("ODP", Englisch: "Ozone Depletion Potential") für die genannten Kältemittel jeweils bei null, das Treibhauspotential ("GWP", Englisch: "Global Warming Potential") oder CO2-Äquivalent liegt jeweils bei lediglich drei.

Es ist erstrebenswert, in heutigen gekühlten Laborgeräten Kältemittel zu verwenden, die günstige Umwelteigenschaften aufweisen. In Bezug auf die genannten Kältemittel Propan und (Iso-)Butan sind hierfür erweiterte Sicherheitsvorkehrungen notwendig. Insbesondere sind sichere Räume innerhalb der Maschine beziehungsweise des Geräts notwendig. Diese Räume müssen insbesondere auch dann sicher bleiben, wenn ein brennbares Kältemittel aus den dafür vorgesehenen Behältern und Leitungen austritt, zum Beispiel im Falle einer Leckage, Beschädigung, oder Fehlfunktion.

US 2019/204388 A1 beschreibt Leistungs-Speichersystem mit einer Speicherbatterie, die mittels einer Mehrzahl von Schaltern von einer Last trennbar ist.

DE 24 10 720 A1 zeigt eine Laborzentrifuge welche mittels zweier Schalter mit Wechselstromanschlüssen verbunden ist.

Der vorliegenden Erfindung liegt das technische Problem zu Grunde, die Betriebssicherheit von gekühlten Laborzentrifugen, die mittels eines entflammbaren Kältemittels gekühlt werden, zu verbessern. Insbesondere ist es ein weiteres, der vorliegenden Erfindung zugrundeliegendes technisches Problem, die Entstehung von Zündfunken innerhalb des Geräts, welche das entflammbare Kältemittel entzünden können, zumindest zeitweise während kritischer Betriebsphasen zu vermeiden und vorzugsweise auszuschließen.

Insbesondere kann es vorgesehen sein, dass zu Beginn eines Betriebes des Laborgeräts ein Innenbereich zunächst mittels eines Lüfters durchlüftet wird, um etwaig vorhandenes entflammbare Kältemittel aus dem Innenbereich insbesondere in die Umgebung hinaus zu lüften. Bei dem belüfteten Innenbereich handelt es sich insbesondere um einen solchen Bereich, in dem Zündfunken entstehen können. Bis davon ausgegangen werden kann, dass sich in dem Innenbereich kein entflammbares Kältemittel mehr befindet, soll die Bildung von Zündfunken ausgeschlossen sein. Dies kann insbesondere dadurch erreicht werden, dass die elektrischen Einrichtungen innerhalb des Geräts vom elektrischen Versorgungsnetz getrennt sind. Das Gerät weist daher vorzugsweise einen elektrischen Anschluss auf, dessen potentiell Strom führende Leitungen sämtlich jeweils durch zumindest einen elektrischen Schalter vom elektrischen Versorgungsnetz trennbar sind. Ausgenommen davon können ein Schutzleiter und/oder eine geerdete Leitung sein. Sämtliche Phasenleitungen und der Nullleiter sind jedoch vorzugsweise jeweils durch zumindest einen elektrischen Schalter vom Versorgungsnetz trennbar.

Wenn nun davon ausgegangen werden kann, dass selbst beim Einschalten der elektrischen Stromversorgung des Geräts ein auftretender Zündfunken kein zündfähiges Gemisch mit entflammbarem Kältemittel entzünden kann, dann kann ein Prozess zum Einschalten begonnen werden. Andererseits soll das Einschalten aber zuverlässig während dieses Prozesses erfolgen und nach dem Einschalten auch zuverlässig überwacht werden können, ob die Stromversorgung noch vorhanden ist. Hierdurch kann die Wahrscheinlichkeit dafür reduziert werden, dass nach dem Einschalten Zündfunken entstehen, etwa durch unbeabsichtigte Unterbrechung der Stromversorgung und sofortiges anschließendes Wiederherstellen der Stromversorgung. Alternativ oder zusätzlich kann durch die Überwachung des Vorhandenseins der Stromversorgung auch nach dem Einschalten der Betrieb des Laborgeräts so ausgeführt werden, dass Zündfunken vermieden werden oder lediglich dann auftreten können, wenn kein fähiges Gemisch entzündet werden kann.

Insbesondere in Zusammenhang mit der Belüftung zumindest eines Innenbereichs des Geräts kann daher die Betriebssicherheit gesteigert werden, wenn das Anliegen einer Betriebsspannung zwischen elektrischen Leitungen des Laborgeräts sicher festgestellt werden kann. Ferner kann diese Feststellung dazu genutzt werden, den Prozess zum Einschalten der Stromversorgung des Geräts sicher zu gestalten.

Es wird vorgeschlagen, bei Anliegen einer elektrischen Betriebsspannung zwischen einem ersten (elektrischen) Kontakt und einem zweiten (elektrischen) Kontakt einen eingeschalteten Zustand eines elektrischen Schalters festzustellen und diesen Zustand zu signalisieren. Dabei liegt der erste Kontakt auf der Geräteseite des elektrischen Schalters (d.h. bei geöffnetem Schalter trennt der Schalter den ersten Kontakt von dem elektrischen Versorgungsnetz) und ist der zweite Kontakt netzseitig mit einem anderen elektrischen Potenzial als die Netzseite des elektrischen Schalters verbunden. "Netzseitig verbunden" bedeutet, dass der zweite Kontakt während der Ausführung des Prozesses zum Einschalten des Geräts durch keinen in den einzelnen elektrischen Versorgungsleitungen des Geräts vorhandenen Schalter vom Netz getrennt ist. Insbesondere befindet sich geräteseitig des zweiten Kontakts ein solcher weiterer Schalter.

Auf diese Weise kann das Anliegen der elektrischen Betriebsspannung an der Geräteseite des zu überwachenden elektrischen Schalters zuverlässig festgestellt werden, denn sie ist nicht von dem Schaltzustand weiterer elektrischer Schalter auf der Geräteseite des zweiten Kontakts in den Versorgungsleitungen abhängig. Dabei ist nicht ausgeschlossen, dass das Anliegen der elektrischen Betriebsspannung doch von dem Schaltzustand eines weiteren Schalters abhängig ist, nämlich eines Schalters, der netzseitig des zweiten Kontakts zum Beispiel als Hauptschalter vorgesehen ist. Während des Prozesses des Einschaltens kann ein solcher Hauptschalter aber zuerst eingeschaltet werden und ist dieser Zustand während des Prozesses daher dem Fall Äquivalent, dass kein Hauptschalter vorhanden ist.

Wenn nun signalisiert wird, dass sich der zu überwachende elektrische Schalter in dem jeweiligen Zustand befindet, und dieser Zustand nicht der erwartete Zustand ist, dann kann dies signalisiert werden und insbesondere eine entsprechende Maßnahme ergriffen werden. Insbesondere kann das Anliegen der elektrischen Betriebsspannung oder deren Nicht-Anliegen einer Ablaufsteuerung des Laborgeräts signalisiert werden. Die Ablaufsteuerung ist ausgestaltet, zumindest zwei elektrische Schalter einer elektrischen Schalteranordnung des Laborgeräts einzuschalten und/oder auszuschalten. Zumindest ein entsprechender Ablauf der Steuerung (d. h. ein Steuerungsprozess mit mehr als einer Aktion), der von der Ablaufsteuerung auszuführen ist, erfordert das Einschalten und/oder Ausschalten zumindest eines der Schalter. Insbesondere im Fall einer einphasigen Stromversorgung des Laborgeräts können zwei Schalter vorhanden sein und von der Ablaufsteuerung steuerbar sein, je ein Schalter in der einzigen Phasenleitung und in dem Nullleiter. Im Fall einer mehrphasigen Stromversorgung kann in jeder der Phasenleitungen ein Schalter vorhanden sein und ein Schalter in dem Mittelpunktsleiter (soweit vorhanden). Im Fall einer Dreiecksschaltung ist kein Mittelpunktsleiter vorhanden. Optional kann sich in zumindest einer der Leitungen nicht nur ein Schalter befinden, sondern zumindest ein weiterer, in Reihe geschalteter Schalter. Auch dieser weitere Schalter kann von der Ablaufsteuerung steuerbar sein.

Der erwartete Zustand des Schalters ergibt sich insbesondere aus dem Prozess, der von der Ablaufsteuerung zu steuern ist. Wenn zum Beispiel zwei elektrische Schalter einzuschalten sind, geht der Prozess davon aus, dass beide Schalter zunächst ausgeschaltet sind. In diesem Stadium des Prozesses wird daher erwartet, dass der ausgeschaltete Zustand signalisiert wird. Vorzugsweise sieht der Prozess vor, dass die Schalter nacheinander eingeschaltet werden. Wenn ein Schalter netzseitig mit dem Nullleiter der Stromversorgung verbunden ist, dann wird dieser Schalter vorzugsweise zuerst eingeschaltet, sofern eine eindeutige und unveränderbare Zuordnung der Schalter zu den elektrischen Leitungen der Stromversorgung besteht. Diese unveränderbare Zuordnung ist zum Beispiel nicht gegeben, wenn das Laborgerät ein Anschlusskabel mit einem Stecker aufweist, der in eine Steckdose eines einphasigen elektrischen Versorgungsnetzes wie in Deutschland eingesteckt werden kann.

Die Ablaufsteuerung kann daher zunächst anhand des ihr übermittelten Signals über den Schaltzustand des Schalters prüfen, ob sich der Schalter in dem erwarteten Zustand befindet. Wenn dies der Fall ist, kann die Ablaufsteuerung im nächsten Schritt des Prozesses diesen Schalter einschalten und danach anhand des ihr übermittelten Signals prüfen, ob der Schalter eingeschaltet ist. Dann kann die Ablaufsteuerung damit fortfahren, den anderen Schalter einzuschalten, wobei sie vor dem Einschalten anhand des ihr übermittelten Signals prüfen kann, ob der andere Schalter sich wie erwartet in dem ausgeschalteten Zustand befindet. Nach dem Einschalten kann die Ablaufsteuerung anhand des ihr übermittelten Signals prüfen, ob der andere Schalter eingeschaltet ist.

In diesem Ausführungsbeispiel hat die Ablaufsteuerung zwei Schalter einzuschalten. In diesem Fall, aber auch wenn lediglich ein Schalter oder mehr als zwei Schalter einzuschalten sind, wird es wie beschrieben bevorzugt, dass die Ablaufsteuerung anhand des ihr übermittelten Signals über den Schaltzustand des Schalters vor dem Einschalten des jeweiligen Schalters prüfen, ob dieser Schalter noch ausgeschaltet ist. Ferner kann die Ablaufsteuerung anhand des ihr übermittelten Signals nach dem Einschalten prüfen, ob der Schalter eingeschaltet ist. Wie bereits erwähnt, kann das Signal ein dauerhaft vorhandenes Signal, wie zum Beispiel ein Signal mit einem definierten Signalpegel sein. Das Signal kann aber auch ein Signal sein, dass lediglich zeitweise anliegt. In diesem Fall registriert die Ablaufsteuerung zum Beispiel den Empfang des Signals und schließt darauf auch für einen Zeitraum in der Zukunft auf den entsprechenden Schaltzustand des Schalters. Auch das Ausbleiben eines Zustandswechsels an einem Signaleingang der Ablaufsteuerung kann das Signal sein. Zum Beispiel kann der eingeschaltete Zustand des Schalters dadurch signalisiert werden, dass einmal oder wiederholt oder dauerhaft ein entsprechendes Signal an dem zugeordneten Signaleingang der Ablaufsteuerung anliegt. Wenn kein solches Signal anliegt, kann die Ablaufsteuerung daraus schließen, dass der Schalter ausgeschaltet ist. Dabei wird bevorzugt, dass im eingeschalteten Zustand des Schalters dauerhaft ein entsprechendes Signal an dem diesem Schalter zugeordneten Signaleingang der Ablaufsteuerung anliegt. Wenn dieses Signal nicht anliegt oder, bei einer anderen Ausführungsform, wenn ein entsprechendes anderes Signal anliegt, bedeutet dies für die Ablaufsteuerung, dass der Schalter eingeschaltet ist. Die nicht nur vorübergehende sondern dauerhafte, ununterbrochene Signalisierung des jeweiligen Schaltzustandes des Schalters oder zumindest eines der beiden Schaltzustände des Schalters erhöht die Sicherheit bei der Überwachung und damit auch die Sicherheit des Betriebes des Laborgerätes.

Nach dem erfolgreichen Einschalten des oder der Schalter kann die Ablaufsteuerung ein Signal ausgeben. Das Signal kann eine Voraussetzung dafür sein, dass der Betrieb zumindest eines elektrischen Verbrauchers des Laborgeräts begonnen werden kann.

Ein für die Sicherheit des Laborgeräts wesentlicher Prozess ist daher der Einschaltprozess zum Einschalten der Stromversorgung, der insbesondere zu Beginn des Betriebs des Laborgeräts durchzuführen ist. Aber auch nach dem Beginn des Betriebes, zum Beispiel wenn die Stromversorgung vorübergehend unterbrochen war, kann dieser Einschaltprozess durchgeführt werden. Insbesondere während des Einschaltprozesses steuert die Ablaufsteuerung das Einschalten der elektrischen Schalter, die zur Herstellung der Stromversorgung einzuschalten sind. Dies schließt jedoch nicht aus, dass die Ablaufsteuerung auch während des Betriebes des Laborgeräts zumindest einen der Schalter einschaltet und/oder ausschaltet. Wenn davon die Rede ist, dass die Ablaufsteuerung einen Schalter einschaltet oder ausschaltet, dann bedeutet dies, dass die Ablaufsteuerung einen entsprechenden Steuerprozess durchführt. Zum Beispiel kann zumindest einer der Schalter als Relais ausgestaltet sein und die Ablaufsteuerung steuert das Relais durch Aktivieren bzw. Deaktivieren des Steuerstromkreises des Relais.

Wenn nun der Ablaufsteuerung ein Zustand zumindest eines der Schalter signalisiert wird, der nicht erwartet wird, dann kann die Ablaufsteuerung den Betrieb des Laborgeräts sperren. Insbesondere kann sie unmittelbar zumindest einen der von ihr steuerbaren elektrischen Schalter und vorzugsweise alle elektrischen Schalter des Laborgeräts, die der Stromversorgung des Laborgeräts dienen, ausschalten.

Insbesondere wird eine Laborzentrifuge nach Anspruch 1 vorgeschlagen.

Ferner wird ein Verfahren zum Herstellen einer Laborzentrifuge nach Anspruch 15 vorgeschlagen.

Außerdem wird ein Verfahren zum Betreiben einer Laborzentrifuge nach Anspruch 9 vorgeschlagen.

Unter einer Betriebsspannung wird eine elektrische Spannung verstanden, die für den Betrieb des Laborgeräts oder zumindest einer elektrischen Einrichtung des Laborgeräts (wie zum Beispiel Zentrifugen-Antriebsmotor) vorgesehen ist oder zumindest dazu ausreicht. Dabei handelt es sich insbesondere um eine elektrische Spannung, die von außerhalb des Laborgeräts von einem elektrischen Versorgungsnetz bereitgestellt wird.

Der zuvor genannte erste elektrische Schalter kann der einzige Schalter sein, der beim Einschalten der Stromversorgung auf seinen Schaltzustand hin überwacht wird. Der erste elektrische Schalter kann aber muss nicht der Schalter sein, der zuerst eingeschaltet wird. Vielmehr wird im Fall einer Stromversorgung mit einer Phasenleitung und einem Nullleiter bevorzugt, dass zumindest der Schalter, der netzseitig mit der Phasenleitung verbunden ist, auf seinen Schaltzustand hin überwacht wird. Besonders bevorzugt wird, dass alle Schalter auf ihre Schaltzustände hin überwacht werden und die Ablaufsteuerung dies beim Prozess des Einschaltens der Schalter berücksichtigt.

Bei dem ersten elektrischen Schalter oder zumindest bei einem der elektrischen Schalter kann es sich zum Beispiel um ein Relais oder um einen steuerbaren Halbleiterschalter handeln, wie zum Beispiel einen Transistor, etwa einen Thyristor, einen Feldeffekttransistor und/oder einen Transistor mit isolierter Steuerelektrode (englisch: Gate), z. B. IGBT. Grundsätzlich kommt jeder steuerbare Schalter infrage. Bei den elektrischen Schaltern handelt sich daher um steuerbare elektrischen Schalter.

Das Signalisieren des Anliegens der Betriebsspannung durch die Überwachungseinrichtung an die Ablaufsteuerung kann verschieden ausgeführt werden. Zum Beispiel kann bei Anliegen der Betriebsspannung permanent ein entsprechendes Signal in Form eines definierten Signalpegels erzeugt werden. Alternativ kann das Entstehen der Betriebsspannung lediglich vorübergehend signalisiert werden, zum Beispiel durch ein impulsförmiges Signal. Ferner kann das Nicht-Vorliegen oder die Nicht-Erzeugung eines definierten Signals das Anliegen der Betriebsspannung signalisieren. Entsprechendes gilt für das Nicht-Anliegen der Betriebsspannung. Es ist insbesondere nicht erforderlich, wenn auch möglich, dass das Anliegen der Betriebsspannung und das Nicht-Anliegen der Betriebsspannung durch die gleiche Art Signal signalisiert wird, wie zum Beispiel ein dauerhaftes Signal mit hohem Signalpegel für das Anliegen der Betriebsspannung und ein dauerhaftes Signal mit niedrigem Signalpegel für das Nicht-Anliegen der Betriebsspannung.

Wie erwähnt, kann der von der Ablaufsteuerung gesteuerte Prozess, in dessen Verlauf der erste Schalter und der zweite Schalter eingeschaltet werden sollen, ein Einschaltprozess zum Einschalten der Stromversorgung des Laborgeräts sein.

Das Sperren des Betriebes des Laborgeräts durch die Ablaufsteuerung kann auf unterschiedliche Weise realisiert werden. Insbesondere kann zumindest eine der folgenden Maßnahmen oder jede sinnvolle Kombination dieser Maßnahmen durchgeführt werden: Zurücksetzen (Reset) des durch die Ablaufsteuerung gesteuerten Prozesses auf einen definierten Zustand, insbesondere den Anfangszustand, Nicht-Einschalten weiterer Schalter, Ausschalten eines oder mehrerer Schalter, insbesondere aller Schalter der Stromversorgung, Nicht-Freigabe des Betriebes zumindest eines und vorzugsweise aller elektrischen Verbraucher innerhalb des Laborgeräts, Ausgeben einer Aufforderung an eine andere Steuerung und/oder an einen Benutzer, den Betrieb des Laborgeräts zu stoppen und/oder nicht zu beginnen.

Insbesondere können der erste und der zweite elektrische Schalter unabhängig voneinander einschaltbar sein, wobei die Ablaufsteuerung ausgestaltet ist, bei Beginn eines Betriebes des Laborgeräts den ersten elektrischen Schalter und den zweiten elektrischen Schalter nacheinander einzuschalten. Wenn beide Schalter auf ihren Schaltzustand hin überwacht werden, und der jeweilige Schaltzustand der Ablaufsteuerung signalisiert wird, kann diese den Einschaltprozess mit erhöhter Sicherheit überwachen und ausführen. Wenn dagegen beide Schalter gleichzeitig eingeschaltet werden und/oder wenn vor dem Einschalten des in der zeitlichen Reihenfolge später einzuschaltenden Schalters nicht geprüft wird, ob der früher einzuschaltende Schalter tatsächlich eingeschaltet ist und auch ob der später einzuschaltende Schalter noch nicht eingeschaltet ist, können beide Schalter trotz eines Fehlers eingeschaltet werden oder kann im Fall einer Stromversorgung mit einer Phasenleitung und einem Nullleiter der Schalter der Phasenleitung eingeschaltet sein, während der Schalter des Nullleiters nicht eingeschaltet ist. Dies kann zu einem Zündfunken führen. Auch kann der Fehler in der Überwachung der Schaltzustände der Schalter bestehen und kann dieser Fehler bei gleichzeitigem Einschalten der Schalter zu spät entdeckt werden. Wenn dann außerdem noch zumindest einer der Schalter defekt ist, können unerwünschte Schaltzustände entstehen. Ein solcher Einschaltprozess wäre daher nicht so sicher wie Einschaltprozess, bei dem die Schalter nacheinander eingeschaltet werden und jeweils anhand der Signalisierung ihres Schaltzustandes vor dem Einschalten und nach dem Einschalten überprüft wird, ob der jeweils erwartete Schaltzustand besteht.

Wie erwähnt sind/werden zumindest zwei Schalter vorgesehen, die zum Einschalten der Stromversorgung einzuschalten sind. Ferner wird wie erwähnt bevorzugt, dass in jeder elektrischen Leitung des Laborgeräts, die für den Betrieb an der Stromversorgung erforderlich ist, zumindest ein elektrischer Schalter vorgesehen ist/wird. Im Fall einer Stromversorgung mit einem Nullleiter und einer einzigen Phasenleitung ist/wird daher für jede dieser beiden Leitungen zumindest ein Schalter vorgesehen. Im Fall einer Stromversorgung mit mehr als einer Phasenleitung ist/wird für jede der Phasenleitungen zumindest ein Schalter vorgesehen. Wenn im Folgenden auf eine bevorzugte Ausführungsform mit einem ersten und einem zweiten elektrischen Schalter eingegangen wird, dann betrifft dies alle Varianten von Stromversorgungen.

Es wird bevorzugt, dass die Überwachungseinrichtung über einen dritten Kontakt geräteseitig mit dem zweiten elektrischen Schalter und über einen vierten Kontakt netzseitig mit einem anderen elektrischen Potenzial als dem zweiten elektrischen Potenzial verbunden ist/wird. Dabei ist/wird die Überwachungseinrichtung ausgestaltet, bei Anliegen einer elektrischen Betriebsspannung zwischen dem dritten Kontakt und dem vierten Kontakt einen eingeschalteten Zustand des zweiten elektrischen Schalters festzustellen und diesen Zustand der Ablaufsteuerung zu signalisieren. Ferner ist/wird die Ablaufsteuerung ausgestaltet,
- wenn erwartet wird, dass der zweite elektrische Schalter ausgeschaltet ist, ihr jedoch von der Überwachungseinrichtung der eingeschaltete Zustand des ersten elektrischen Schalters signalisiert wird, oder
- wenn erwartet wird, dass der zweite elektrische Schalter eingeschaltet ist, ihr jedoch von der Überwachungseinrichtung der ausgeschaltete Zustand des ersten elektrischen Schalters signalisiert wird,
einen Betrieb des Laborgeräts zu sperren. Bezüglich des Verfahrens zum Betreiben des Laborgerätes kann die Ablaufsteuerung entsprechend betrieben werden und in den genannten Fällen den Betrieb des Laborgeräts sperren.

Insbesondere können die Überwachungseinrichtung und die Ablaufsteuerung bezüglich der Überwachung und bezüglich dem Einschalten des zweiten elektrischen Schalters optional genauso ausgestaltet sein wie bezüglich des ersten elektrischen Schalters. Wie zuvor erwähnt, kann der zweite elektrische Schalter auch ein Schalter sein, der beim Einschalten der Stromversorgung des Laborgerätes vor dem ersten elektrischen Schalter eingeschaltet wird.

Die zuvor genannte Ausführungsform mit dem dritten Kontakt und dem vierten Kontakt ist eine Realisierung des bereits erwähnten bevorzugten Prinzip der Überwachung zweier Schalter. Die Ablaufsteuerung kann ausgestaltet sein/werden, bzw. entsprechend arbeiten,
- einen Prozess zum Einschalten des ersten elektrischen Schalters zu starten, wenn ihr von der Überwachungseinrichtung ein erster vorgegebener Zustand der elektrischen Schalteranordnung signalisiert wird, zu dem es gehört, dass der erste elektrische Schalter ausgeschaltet ist,
- anschließend zu prüfen, ob ihr von der Überwachungseinrichtung der eingeschaltete Zustand des ersten elektrischen Schalters signalisiert wird, und
- den Betrieb des Laborgeräts zu sperren oder einen von ihr zu steuernden Prozess zu stoppen, wenn ihr von der Überwachungseinrichtung der eingeschaltete Zustand des ersten elektrischen Schalters nicht signalisiert wird.

Das Starten des Prozesses zum Einschalten des ersten elektrischen Schalters kann insbesondere ein Steuern und/oder Auslösen des Einschaltens sein. Der erste vorgegebene Zustand kann allein durch den Schaltzustand des ersten elektrischen Schalters bestimmt sein. Vorzugsweise, wenn insbesondere wie oben bereits beschrieben mehr als ein Schalter der Schalteranordnung auf seinen Schaltzustand hin überwacht wird, ist der erste vorgegebene Zustand der elektrischen Schalteranordnung aber durch den Schaltzustand einer Mehrzahl der Schalter der Schalteranordnung bestimmt. Wenn daher zum Beispiel der erste elektrische Schalter der in der Reihenfolge zweier Schalter später einzuschaltende Schalter ist, erfordert es der erste vorgegebene Zustand, dass der andere, früher einzuschaltende Schalter bereits eingeschaltet ist. Wenn dagegen der erste elektrische Schalter der in der Reihenfolge zweier Schalter früher einzuschaltenden Schalter ist, erfordert es der erste vorgegebene Zustand, dass der andere, später einzuschaltende Schalter ausgeschaltet ist. Insbesondere können wie oben beschrieben zur Überwachung des Schaltzustandes des zweiten elektrischen Schalters der dritte und vierte Kontakt verwendet werden.

Die Überwachungseinrichtung kann insbesondere für die Überwachung jedes im Hinblick auf den Schaltzustand zu überwachenden elektrischen Schalters eine Feststelleinrichtung aufweisen, die ausgestaltet ist/wird, bei Anliegen der elektrischen Betriebsspannung zwischen den beiden Kontakten den eingeschalteten Zustand des elektrischen Schalters festzustellen und diesen Zustand der Ablaufsteuerung zu signalisieren. Wie noch im Folgenden näher beschrieben wird, muss es sich bei den beiden Kontakten nicht um ein Kontakt-Paar handeln, bei dem einer der Kontakte geräteseitig des elektrischen Schalters und der andere der beiden Kontakte netzseitig angeordnet sind, wie oben bereits beschrieben. Vielmehr können insbesondere auch die Schaltzustände zweier elektrischer Schalter in verschiedenen Leitungen für die Stromversorgung (zum Beispiel Nullleiter und Phasenleitung) des Laborgeräts mittels einer einzigen Feststelleinrichtung auf den Schaltzustand überwacht werden. Dabei kann lediglich zwischen dem eingeschalteten Zustand beider Schalter einerseits und einem anderen Zustand andererseits unterschieden werden. Der andere Zustand besteht, wenn zumindest einer der beiden Schalter ausgeschaltet ist.

Insbesondere wird es bevorzugt, dass auf diese Weise die zwei elektrischen Schalter auf ihren Schaltzustand hin überwacht werden und zusätzlich zumindest einer dieser beiden elektrischen Schalter einzeln (wie bereits beschrieben) auf seinen Schaltzustand hin überwacht wird. Die Überwachung bedeutet dabei, dass wie bereits mehrfach erwähnt der entsprechende Zustand der Ablaufsteuerung signalisiert wird und diese den Zustand vorzugsweise auch dabei berücksichtigt, ob der von ihr zu steuernde Prozess fortgeführt wird. Zumindest einer der Schalter wird daher redundant auf seinen Schaltzustand überwacht. Dies ermöglicht es der Ablaufsteuerung, die Funktion der Überwachungseinrichtung zu prüfen und eine Fehlfunktion festzustellen. Insbesondere wird es bevorzugt, dass im Fall einer Fehlfunktion der von der Ablaufsteuerung gesteuerte Prozess von ihr unterbrochen wird, von ihr abgebrochen wird und/oder von ihr der Betrieb des Laborgeräts gesperrt wird.

Das Laborgerät kann daher insbesondere wie folgt ausgestaltet sein/werden, bzw. entsprechend arbeiten:
- die Überwachungseinrichtung weist eine erste Feststelleinrichtung auf, die ausgestaltet ist, bei Anliegen der elektrischen Betriebsspannung zwischen dem ersten Kontakt und dem zweiten Kontakt den eingeschalteten Zustand des ersten elektrischen Schalters festzustellen und diesen Zustand der Ablaufsteuerung zu signalisieren,
- die Überwachungseinrichtung ist über einen fünften Kontakt geräteseitig mit dem ersten elektrischen Schalter und über einen sechsten Kontakt geräteseitig mit dem zweiten elektrischen Schalter verbunden,
- die Überwachungseinrichtung weist eine dritte Feststelleinrichtung auf, die ausgestaltet ist, bei Anliegen der elektrischen Betriebsspannung zwischen dem fünften Kontakt und dem sechsten Kontakt einen eingeschalteten Zustand des ersten elektrischen Schalters und des zweiten elektrischen Schalters festzustellen und diesen Zustand der Ablaufsteuerung zu signalisieren, und
- die Ablaufsteuerung ist ausgestaltet, den Betrieb des Laborgeräts zu sperren oder einen von ihr gesteuerten Prozess zu stoppen, wenn ihr nach einem Einschalten des ersten elektrischen Schalters und des zweiten elektrischen Schalters nicht sowohl von der ersten Feststelleinrichtung als auch von der dritten Feststelleinrichtung der jeweilige eingeschaltete Zustand signalisiert wird.

Insbesondere kann die Ablaufsteuerung außerdem noch prüfen, ob ihr der jeweilige eingeschaltete Zustand von der ersten Feststelleinrichtung und von der dritten Feststelleinrichtung innerhalb einer vorgegebenen Zeitspanne signalisiert wird. Wenn dies nicht der Fall ist, kann die Ablaufsteuerung den Betrieb des Laborgeräts sperren oder den von ihr gesteuerten Prozess stoppen. Hierdurch können insbesondere Fehlfunktionen der Überwachungseinrichtung von der Ablaufsteuerung bemerkt werden.

Insbesondere kann auch eine zweite Feststelleinrichtung vorgesehen sein/werden, die ausgestaltet ist, bei Anliegen der elektrischen Betriebsspannung zwischen dem dritten Kontakt und dem vierten Kontakt den eingeschalteten Zustand des zweiten elektrischen Schalters festzustellen und diesen Zustand der Ablaufsteuerung zu signalisieren. In diesem Fall kann die Ablaufsteuerung, den Betrieb des Laborgeräts sperren oder einen von ihr gesteuerten Prozess stoppen, wenn ihr nach einem Einschalten des ersten elektrischen Schalters und des zweiten elektrischen Schalters nicht sowohl von der ersten Feststelleinrichtung, als auch von der zweiten Feststelleinrichtung und auch von der dritten Feststelleinrichtung der jeweilige eingeschaltete Zustand signalisiert wird. Hierdurch wird die Prüfung der Überwachungseinrichtung auf Fehler noch zuverlässiger.

Die Überwachungseinrichtung kann zumindest eine Einrichtung aufweisen, die zumindest eine bistabile Kippstufe aufweist. Zumindest während die bistabile Kippstufe an ihre Stromversorgung angeschlossen ist, wird einer von zwei möglichen Zuständen der Kippstufe stabil beibehalten, bis die Voraussetzungen für einen Wechsel des Zustandes eingetreten sind. Übliche bistabile Kippstufen weisen einen Dateneingang und einen Triggereingang auf. Wenn an dem Triggereingang ein Triggersignal eingeht, wie zum Beispiel ein Wechsel des Pegels des Eingangssignals an dem Triggereingang, kann der Wechsel des Zustandes stattfinden, sofern auch am Dateneingang ein entsprechender Wechsel des Datensignals stattfindet. Insbesondere kann dann das Datensignal wie am Dateneingang anliegend (oder bei einer anderen Ausgestaltung invertiert) auf den Ausgang der bistabilen Kippstufe durchgeschaltet werden.

Es wird bevorzugt, dass die für die Prozesssteuerung innerhalb der Ablaufsteuerung vorhandene Logik durch Hardware und vorzugsweise ausschließlich durch Hardware realisiert wird. Hardware von Logikschaltungen kann insbesondere aus Logik-Gattern, bistabilen Kippstufen und Schmitt-Triggern sowie klassischen elektrischen Bauteilen wie Widerständen, Kondensatoren und Dioden bestehen. Der Vorteil von einer Hardware-Logik gegenüber Software-Logik besteht darin, dass nicht wie bei den üblicherweise erforderlichen Aktualisierungen der Software eine erneute Zulassung beantragt werden muss. Wenn die Hardware-Logik den Anforderungen entspricht und ihre Funktion erfüllt, ist keine Aktualisierung erforderlich.

Insbesondere kann der bereits erwähnte Prozess zum Einschalten der Stromversorgung des Laborgeräts zumindest teilweise durch Hardware-Logik der Ablaufsteuerung realisiert werden. Gemäß einer Ausgestaltung weist die Ablaufsteuerung eine elektronische Schaltung mit einer bistabilen Kippstufe auf, wobei die bistabile Kippstufe eingangsseitig mit einer ersten Signalleitung verbunden ist, über die der bistabilen Kippstufe von der Überwachungseinrichtung signalisiert wird, dass der erste elektrische Schalter eingeschaltet ist. Ausgangsseitig ist die bistabile Kippstufe mit einer zweiten Signalleitung verbunden, über die die bistabile Kippstufe abhängig von einem über die erste Signalleitung übertragenen Signal und abhängig von einem weiteren Signal signalisiert, dass der Einschaltprozesses zum Einschalten des Laborgeräts von der Ablaufsteuerung fortgesetzt werden kann oder dass der Einschaltprozesses erfolgreich war.

Das weitere Signal ist insbesondere das Signal, das bei der oben beschriebenen Realisierung der bistabilen Kippstufe an dem Triggereingang anliegt bzw. angelegt wird. Ohne das Triggersignal wird das an der ersten Signalleitung, der Datenleitung, anliegende Signal nicht (unverändert oder invertiert) auf den Ausgang gegeben. Allgemein, nicht nur bezogen auf die Ausgestaltung mit dem Dateneingang und dem Triggereingang, kann das weitere Signal davon abhängen, dass ein Startsignal zum Starten des von der Ablaufsteuerung zu steuernden Prozesses vorhanden ist oder gegeben wurde und/oder dass ein Signal erzeugt wurde, das die erfolgreiche Ausführung eines vorangegangenen Prozessschrittes (zum Beispiel eines Schrittes der Einschaltung eines anderen elektrischen Schalters) signalisiert.

Die bistabile Kippstufe ist ein wesentliches Logikelement bezüglich des Prozessablaufs. Insbesondere kann die Auswertung der Signale der oben erwähnten Feststelleinrichtungen in dieser Weise realisiert werden. Dabei bezieht sich die Realisierung dann nicht auf den ersten elektrischen Schalter, sondern auf den zweiten elektrischen Schalter oder auf zwei, gemeinsam mittels einer einzigen Feststelleinrichtung zu überwachende elektrische Schalter. Daher kann die bistabile Kippstufe eingangsseitig mit einer ersten Signalleitung verbunden sein, über die der bistabilen Kippstufe von der Überwachungseinrichtung signalisiert wird, dass der erste elektrische Schalter und der zweite elektrische Schalter eingeschaltet sind.

Bei einer vorteilhaften Ausgestaltung hängt das weitere Signal (insbesondere das Signal am Triggereingang) auch davon ab, dass der bistabilen Kippstufe von der Überwachungseinrichtung der eingeschaltete Zustand des ersten elektrischen Schalters signalisiert wird. Wenn daher der Überwachungseinrichtung nicht der eingeschaltete Zustand signalisiert wird, verhindert dies, dass die bistabile Kippstufe an ihrem Ausgang signalisiert, dass der Einschaltprozesses zum Einschalten des Laborgeräts von der Ablaufsteuerung fortgesetzt werden kann oder dass der Einschaltprozesses erfolgreich war. Die bistabile Kippstufe signalisiert daher nur dann, dass der Einschaltprozesses zum Einschalten des Laborgeräts von der Ablaufsteuerung fortgesetzt werden kann oder dass der Einschaltprozesses erfolgreich war, wenn der erste Schalter tatsächlich eingeschaltet ist. Dadurch werden Fehler der Ablaufsteuerung vermieden, die im Fall eines Defekts des einzuschaltenden Schalters und auch eines Defekts der bistabilen Kippstufe auftreten könnten. Insbesondere kann der Defekt der bistabilen Kippstufe darin bestehen, dass am Dateneingang permanent das Anliegen desjenigen Signals detektiert wird, welches den eingeschalteten Zustand des elektrischen Schalters signalisiert. Im Fall der oben beschriebenen Ausführungsform mit Triggereingang wird bei defektem Schalter verhindert, dass die bistabile Kippstufe das Triggersignal erhält, welches die Ausgabe des Signals an ihrem Signalausgang ermöglicht.

Gemäß einer weiteren Ausgestaltung kann die Ablaufsteuerung eine Testeinrichtung mit einer Simulationseinrichtung aufweisen, die ausgestaltet ist, bei aktivierter Simulationseinrichtung für einen Steuerungsprozess der Ablaufsteuerung, der zum Einschalten des ersten elektrischen Schalters auszuführen ist, zu simulieren, dass der erste elektrische Schalter nicht eingeschaltet wird. Wie erwähnt muss es sich bei dem elektrischen Schalter nicht um den zuerst eingeschalteten Schalter handeln. Auch kann für eine Mehrzahl der elektrischen Schalter simuliert werden, dass der jeweilige Schalter nicht eingeschaltet wird. Die Testeinrichtung ist/wird dabei ausgestaltet, bei aktivierter Simulationseinrichtung zu prüfen, ob die Ablaufsteuerung nach einem Durchlauf des Steuerungsprozesses einen Betrieb des Laborgeräts freigibt. Die Testeinrichtung signalisiert dann einen Fehler der Ablaufsteuerung, wenn die Ablaufsteuerung bei aktivierter Simulationseinrichtung zu dem Ergebnis kommt, dass die Voraussetzungen für eine Freigabe des Betriebes des Laborgeräts erfüllt sind. Insbesondere führte die Signalisierung des Fehlers dazu, dass der Betrieb nicht freigegeben wird. Bei Realisierung der Ablaufsteuerung durch Hardware-Logik kann die Testeinrichtung zum Beispiel durch zusätzliche Logik-Gatter realisiert werden. Wird dann zum Beispiel zu Beginn eines von der Ablaufsteuerung auszuführenden Steuerungsprozesses auf eines oder mehrere der Logik-Gatter ein Testsignal gegeben, aktiviert dies die Simulation.

Ausführungsbeispiele und weitere Ausgestaltungen der Erfindung werden nun unter Bezugnahme auf die beigefügte Zeichnung beschrieben. Die einzelnen Figuren der Zeichnung zeigen:
- Fig. 1: schematisch ein Laborgerät mit einem elektrischen Anschluss und mit einer Kühleinrichtung, welche ein entflammbares Kältemittel verwendet,
- Fig. 2: ein erstes Ausführungsbeispiel einer elektrischen Schalteranordnung, einer Überwachungseinrichtung und einer Ablaufsteuerung,
- Fig. 3: ein zweites Ausführungsbeispiel einer elektrischen Schalteranordnung, einer Überwachungseinrichtung und einer Ablaufsteuerung,
- Fig. 4: ein drittes Ausführungsbeispiel einer elektrischen Schalteranordnung, einer Überwachungseinrichtung und einer Ablaufsteuerung,
- Fig. 5: eine erste Schaltungsanordnung mit einer bistabilen Kippstufe,
- Fig. 6: eine zweite Schaltungsanordnung mit einer bistabilen Kippstufe,
- Fig. 7: eine dritte Schaltungsanordnung mit einer bistabilen Kippstufe,
- Fig. 8: eine vierte Schaltungsanordnung mit einer bistabilen Kippstufe und
- Fig. 9: eine Schaltungsanordnung mit zwei bistabilen Kippstufen.

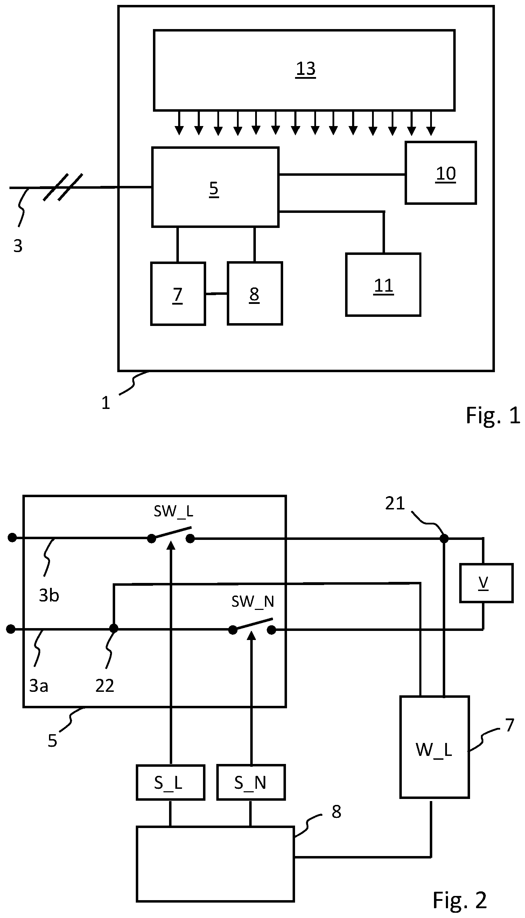

Das in Fig. 1 schematisch dargestellte Laborgerät 1 weist einen elektrischen Anschluss 3 auf, der wie durch zwei diagonale Striche angedeutet ist zwei elektrische Leitungen aufweist. Dabei 16 kann es sich insbesondere um einen Nullleiter und eine Phasenleitung handeln. Alternativ kann das Laborgerät einen elektrischen Anschluss mit mehr als einer Phasenleitung aufweisen, zum Beispiel einen Drehstromanschluss.

Das Laborgerät 1 weist ferner eine elektrische Schalteranordnung 5 auf. Durch Einschalten von nicht in Fig. 1 dargestellten Schaltern der Schalteranordnung 5 können mit elektrischer Energie zu versorgende Einrichtungen 10, 11, wie zum Beispiel ein Zentrifugenmotor und eine Zentrifugensteuerung, an die externe Stromversorgung angeschlossen werden.

Die elektrische Schalteranordnung 5 ist mit einer Überwachungseinrichtung 7 und einer Ablaufsteuerung 8 zum kombiniert. Die Überwachungseinrichtung 7 dient der Überwachung der elektrischen Schalteranordnung 5. Die Ablaufsteuerung 8 dient der Steuerung zumindest eines Prozesses, der zu Beginn und/oder während des Betriebes des Laborgeräts 1 auszuführen ist. Insbesondere betreffen die von der Ablaufsteuerung 8 zu steuernden Prozesse ausschließlich die elektrische Energieversorgung von Einrichtungen des Laborgeräts. Die Ablaufsteuerung 8 erhält während ihres Betriebes Signale von der Überwachungseinrichtung 7.

Ferner weist das Laborgerät 1 eine Kühleinrichtung 13 auf, die ein entflammbares Kältemittel verwendet. Die während des Betriebes der Kühleinrichtung 13 erzeugte Kühlwirkung ist durch eine Anzahl von nach unten weisender Pfeilen angedeutet. Auch die Kühleinrichtung 13 kann über die Schalteranordnung 5 mit elektrischer Energie aus der externen Stromversorgung versorgt werden, wozu die elektrischen Schalter der Schalteranordnung 5 eingeschaltet sein müssen. Im Gegensatz dazu werden die Überwachungseinrichtung 7 und die Ablaufsteuerung 8 unabhängig von dem Schaltzustand der Schalter der Schalteranordnung 5 mit elektrischer Energie versorgt. Hierzu kann eine separate Stromversorgung vorgesehen sein, die aber vorzugsweise auch mit Energie aus der genannten externen Stromversorgung versorgt wird.

Fig. 2 zeigt ein erstes Ausführungsbeispiel der elektrischen Schalteranordnung 5 aus Fig. 1 oder einer entsprechenden Schalteranordnung eines anderen Laborgeräts. Die externe Stromversorgung und somit auch die Schalteranordnung 5 weisen eine erste elektrische Leitung 3a (zum Beispiel ein Nullleiter N) und eine zweite elektrische Leitung 3b (zum Beispiel eine Phasenleitung) auf. Zum Beispiel kann die externe Stromversorgung an einem öffentlichen elektrischen Versorgungsnetz betrieben werden mit der jeweils verfügbaren Spannung und Netzfrequenz, die zum Beispiel in Deutschland nominal 230 V und 50 Hz betragen.

In der ersten elektrischen Leitung 3a ist ein elektrischer Schalter SW_N angeordnet. In der zweiten elektrischen Leitung 3b ist ein weiterer elektrischer Schalter SW_L angeordnet. In geöffnetem Zustand des jeweiligen Schalters sind jedenfalls die während des Betriebes des Laborgerätes von der externen Stromversorgung zu versorgenden Einrichtungen von der Stromversorgung getrennt und können daher nicht betrieben werden. Für deren Betrieb sind beide elektrischen Schalter SW_N, SW_L einzuschalten.

Die Überwachungseinrichtung 7 weist in dem Ausführungsbeispiel eine einzige Feststelleinrichtung W_L auf, die ausgestaltet ist, den Schaltzustand des Schalters SW_L in der zweiten elektrischen Leitung 3b zu überwachen. Die Feststelleinrichtung W_L ist über einen ersten Kontakt 21 geräteseitig mit dem elektrischen Schalter SW_L in der zweiten elektrischen Leitung 3b und über einen zweiten Kontakt 22 netzseitig mit einem anderen elektrischen Potenzial als dem elektrischen Potenzial der zweiten elektrischen Leitung 3b verbunden. Dieses andere elektrische Potenzial ist das elektrische Potenzial der ersten elektrischen Leitung 3a. Der zweite Kontakt 22 befindet sich daher netzseitig des elektrischen Schalters SW_N in der ersten elektrischen Leitung 3a. Die Feststelleinrichtung W_L weist zum Beispiel, wie auch die Feststelleinrichtungen anderer Ausführungsformen, einen Optokoppler auf. Liegt daher die elektrische Betriebsspannung zwischen den Kontakten 21, 22 an, erzeugt der Optokoppler ein entsprechendes Signal, das den eingeschalteten Zustand des Schalters SW_L in der zweiten elektrischen Leitung 3b signalisiert. Dieses Signal wird der Ablaufsteuerung 8 zugeführt. Die elektrische Betriebsspannung liegt lediglich dann zwischen den Kontakten 21, 22 an, wenn der Schalter SW_L in der zweiten elektrischen Leitung 3b eingeschaltet ist. Andernfalls befindet sich das elektrische Potenzial an dem ersten Kontakt 21 nicht auf dem Potenzial der Phasenleitung der externen Stromversorgung.

Die Ablaufsteuerung 8 steuert das Einschalten der beiden elektrischen Schalter SW_N, SW_L über jeweils ein Stellglied S_N, S_L. Durch die Stellglieder wird bei entsprechender Ansteuerung durch die Ablaufsteuerung 8 zum Beispiel der jeweilige Steuerstromkreis des Schalters aktiviert, zum Beispiel der Steuerstromkreis eines Relais.

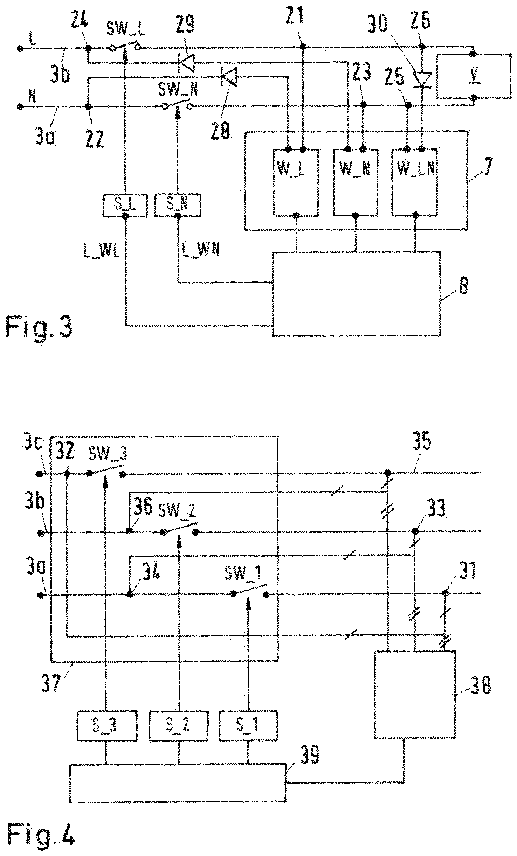

Fig. 3 zeigt ein zweites Ausführungsbeispiel der elektrischen Schalteranordnung 5 aus Fig. 1 oder einer entsprechenden Schalteranordnung eines anderen Laborgeräts. Dieses Ausführungsbeispiel kann bei derselben Stromversorgung mit zwei Versorgungsleitungen 3a, 3b angewendet werden, wie in den Fällen der Fig. 1 und Fig. 2. Zum Beispiel handelt es sich bei den Versorgungsleitungen wieder um eine Phasenleiter und einen Nullleiter, wie durch die Buchstaben L, N angedeutet ist.

Gegenüber dem ersten Ausführungsbeispiel aus Fig. 2 ist die Überwachungseinrichtung 7 um zwei weitere Feststelleinrichtungen W_N und W_LN erweitert. Die Feststelleinrichtung W_L ist wie im Fall der Fig. 1 vorhanden und weist dieselben Kontakte 21, 22 zu den Versorgungsleitungen 3a, 3b auf. In der Verbindungsleitung der Feststelleinrichtung W_L ist jedoch zusätzlich eine Diode 28 angeordnet, die gemeinsam mit zwei weiteren Dioden 29, 30 in den Verbindungsleitungen der zwei weiteren Feststelleinrichtungen W_N und W_LN zu der zweiten Versorgungsleitung 3b verhindert, dass ein unbeabsichtigter Stromfluss über eine Kette von Verbindungsleitungen zwischen den beiden Versorgungsleitungen 3a, 3b auftreten kann. Um diesen unbeabsichtigten Stromfluss zu verhindern, kann auch auf die eine weitere Diode 30 verzichtet werden. Ihre Verwendung wird jedoch bevorzugt, um eine Symmetrie in der Schaltungsanordnung zu erreichen. Da es sich in dem Ausführungsbeispiel um eine Wechselstromversorgung handelt, findet daher über die Verbindungsleitungen im jeweiligen eingeschalteten Zustand des oder der Schalter jeweils nur in einer Halbwelle jedes Zyklus der Versorgungsspannung ein Stromfluss statt. Dies reicht den Feststelleinrichtungen W_L, W_N und W_LN (die beispielsweise wiederum jeweils durch einen Optokoppler realisiert sind) jedoch aus, den eingeschalteten Zustand festzustellen.

Die Feststelleinrichtung W_N ist über ihre beiden Verbindungsleitungen geräteseitig mit einem dritten Kontakt 23 zu der ersten Versorgungsleitung 3a und netzseitig mit einem vierten Kontakt 24 zu der zweiten Versorgungsleitung 3b verbunden. Sie ist somit ausgestaltet, den Schaltzustand des elektrischen Schalters SW_N in der ersten Versorgungsleitung 3a festzustellen.

Die Feststelleinrichtung W_LN ist über ihre beiden Verbindungsleitungen geräteseitig mit einem fünften Kontakt 25 zu der ersten Versorgungsleitung 3a und geräteseitig mit einem sechsten Kontakt 26 zu der zweiten Versorgungsleitung 3b verbunden. Sie ist somit ausgestaltet, den Schaltzustand beider Schalter, des elektrischen Schalters SW_N in der ersten Versorgungsleitung 3a und des elektrischen Schalters SW_L in der zweiten Versorgungsleitung 3b festzustellen. Sie kann wie oben bereits beschrieben lediglich feststellen, ob beide Schalter eingeschaltet sind oder zumindest einer der beiden Schalter ausgeschaltet ist. Auf die Funktion und die Vorteile einer solchen zusätzlichen Feststelleinrichtung wurde bereits eingegangen.

Fig. 4 zeigt ein drittes Ausführungsbeispiel einer elektrischen Schalteranordnung 37 eines Laborgeräts, wobei sich die elektrische Schalteranordnung 37 von der elektrischen Schalteranordnung 5 aus Fig. 1 unterscheidet, da die elektrische Stromversorgung drei Phasenleitungen 3a, 3b, 3c aufweist. Die Schalteranordnung 37 weist in jeder der drei Phasenleitungen einen Schalter SW_1, SW_2 bzw. SW_3 auf. Die Ablaufsteuerung 39 steuert das Einschalten der drei elektrischen Schalter über jeweils ein Stellglied S_1, S_2, S_3. Durch die Stellglieder wird bei entsprechender Ansteuerung durch die Ablaufsteuerung 39 zum Beispiel der jeweilige Steuerstromkreis des Schalters aktiviert, zum Beispiel der Steuerstromkreis eines Relais.

Die Darstellung ist gegenüber der Darstellung des zweiten Ausführungsbeispiels der elektrischen Schalteranordnung 5 aus Fig. 3 vereinfacht. Insbesondere sind die Dioden in den Verbindungsleitungen der Überwachungseinrichtung 38 zu den elektrischen Versorgungsleitungen nicht dargestellt, obwohl sie wie auch im Fall der Fig. 3 vorhanden sind. Dies dient der Übersichtlichkeit der Darstellung. Ferner sind die Verbindungsleitungen der Überwachungseinrichtung 38 ebenfalls der besseren Übersichtlichkeit wegen abschnittsweise durch eine einzige Linie dargestellt, obwohl es sich um zwei Verbindungsleitungen handelt. Dies ist durch zwei diagonale und parallel zueinander verlaufende Striche dargestellt. Dort, wo die Linie nur eine Verbindungsleitung darstellt, ist ein diagonal verlaufender Strich gezeichnet.

Bei dem dritten Ausführungsbeispiel weist die Überwachungseinrichtung 38 drei Feststelleinrichtungen auf, die aus Gründen der Übersichtlichkeit nicht einzeln dargestellt sind. Jeder dieser Feststelleinrichtungen ist über ihre Verbindungsleitungen mit zwei Kontakten in den drei Versorgungsleitungen 3a, 3b, 3c verbunden und zwar jeweils mit einem Kontakt geräteseitig des Schalters in der Versorgungsleitung und einem Kontakt netzseitig in einer anderen Versorgungsleitung. Zum Beispiel ist eine erste der Feststelleinrichtungen über einen ersten Kontakt 31 geräteseitig des Schalters SW_1 mit der ersten Versorgungsleitung 3a verbunden und über einen zweiten Kontakt 32 netzseitig des dritten Schalters SW_3 mit der dritten Versorgungsleitung 3c verbunden.

Optional kann zumindest eine weitere Feststelleinrichtung vorhanden sein, die den gemeinsamen eingeschalteten Zustand von zwei der drei Schalter feststellen kann. Diese weitere Feststelleinrichtung hätte jeweils über einen Kontakt geräteseitig Verbindung zu den beiden zu überwachenden Schaltern.

Alternativ oder zusätzlich kann die in Fig. 4 dargestellte Anordnung im Fall einer dreiphasigen Drehstromversorgung mit Mittelpunktsleiter um eine Feststelleinrichtung erweitert werden, die den eingeschalteten Zustand eines Schalters im Mittelpunktsleiter feststellen kann.

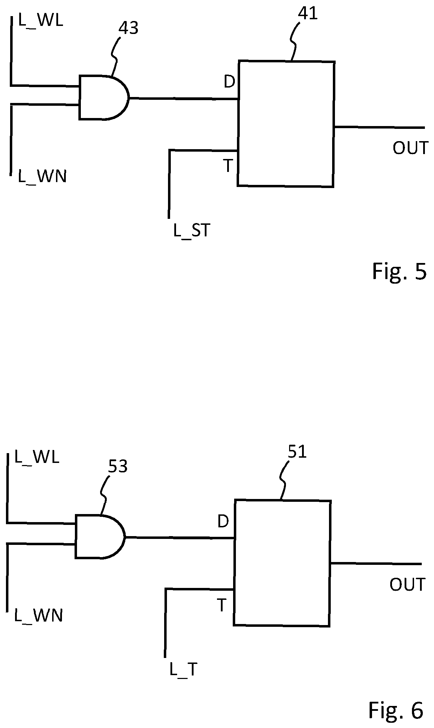

Die in Fig. 5 dargestellte Schaltung kann Teil einer in Hardware ausgeführten Logik der Ablaufsteuerung sein, zum Beispiel der Ablaufsteuerung in einem der zuvor beschriebenen Ausführungsbeispiele. Die Schaltung weist ein Logik-Gatter 43 und eine bistabile Kippstufe 41 auf. Die bistabile Kippstufe 41 weist einen Dateneingang D und einen Triggereingang T auf. Ferner weist sie einen Ausgang OUT zum Ausgeben ihres Ausgangssignals auf.

In dem dargestellten Ausführungsbeispiel werden dem Logik-Gatter 43 zwei Eingangssignale L_WN und L_WL zugeführt. Das Eingangssignal L_WN gibt beispielsweise den Schaltzustand des elektrischen Schalters SW_N in der ersten Versorgungsleitung 3a des Ausführungsbeispiels aus Fig. 2 oder Fig. 3 wieder. Das Eingangssignal L_WL gibt beispielsweise den Schaltzustand des elektrischen Schalters SW_L in der zweiten Versorgungsleitung 3b des Ausführungsbeispiels aus Fig. 3 wieder. Durch nicht dargestellte zusätzliche Schaltungselemente, wie beispielsweise weitere Logik-Gatter und/oder Schmitt-Trigger, können die Eingangssignale L_WN und L_WL je nach Ausgestaltung der Schaltung vor ihrer Zuführung zu den Eingängen des Logik-Gatters in unterschiedlicher Weise miteinander verknüpft werden und/oder mit weiteren Signalen verknüpft werden. Alle Signale sind vorzugsweise Signale mit zwei möglichen Zuständen, zum Beispiel einem Zustand mit niedrigem Signalpegel und einem Zustand mit hohem Signalpegel. Auf diese Weise kann eine binäre Logik realisiert werden.

Beispielsweise sind die Eingangssignale L_WN und L_WL in der im Folgenden beschriebenen Ausgestaltung so verknüpft und das Logik-Gatter 43 so ausgestaltet, dass das Logik-Gatter 43 ein Signal mit hohem Signalpegel ausgibt, wenn beide Eingangssignale L_WN und L_WL den niedrigen Signalpegel haben. Der niedrige Signalpegel der Eingangssignale L_WN und L_WL bedeutet in diesem Fall, dass die Schalter ausgeschaltet sind. Alternativ sind die Eingangssignale L_WN und L_WL z. B. so verknüpft und das Logik-Gatter 43 so ausgestaltet, dass das Logik-Gatter 43 ein Signal mit hohem Signalpegel ausgibt, wenn beide Eingangssignale L_WN und L_WL den hohen Signalpegel haben. Der hohe Signalpegel der Eingangssignale L_WN und L_WL bedeutet in diesem Fall, dass die Schalter ausgeschaltet sind. Um dies zu erreichen können die von den Feststelleinrichtungen erzeugten Signale, die den Schaltzustand des jeweiligen Schalters wiedergeben, zum Beispiel invertiert werden.

In der hier beschriebenen Ausgestaltung kann dem Logik-Gatter 43 insbesondere zu Beginn eines von der Ablaufsteuerung gesteuerten Prozesses zum Einschalten der beiden elektrischen Schalter ein Startsignal L_ST zugeführt werden, wobei das Startsignal darin besteht, dass der niedrige Signalpegel am Triggereingang T der bistabilen Kippstufe 41 zu dem hohen Signalpegel wechselt. Vor dem Empfang des Startsignals befindet sich der Ausgang OUT der bistabilen Kippstufe 41 auf dem niedrigen Signalpegel. Durch das Startsignal L_ST wird das Durchschalten des Eingangssignals am Dateneingang D der bistabilen Kippstufe 41 auf deren Ausgang OUT ermöglicht. Da wie beschrieben das Logik-Gatter 43 ein Signal mit hohem Signalpegel auf den Dateneingang D ausgibt, wenn beide Schalter ausgeschaltet sind, und da der hohe Signalpegel am Ausgang OUT so interpretiert wird, dass der erwartete Zustand der Schalteranordnung aus dem ersten Schalter und dem zweiten Schalter besteht, ist eine Logik-Schaltung realisiert, die den ausgeschalteten Zustand beider Schalter überprüft. Wenn die Überprüfung erfolgreich ist, d. h. der hohe Signalpegel am Ausgang OUT der bistabilen Kippstufe 41 anliegt, wird dadurch der nächste Schritt in dem von der Ablaufsteuerung gesteuerten Prozess angestoßen.

Ein solcher nächster Schritt oder ein später im Prozess auszuführender Schritt wird nun anhand der in Fig. 6 dargestellten Schaltung beschrieben. Diese Schaltung unterscheidet sich von der in Fig. 5 dargestellten lediglich dadurch, dass die bistabile Kippstufe mit dem Bezugszeichen 51 bezeichnet ist und das Logik-Gatter mit dem Bezugszeichen 53 bezeichnet ist. Ferner wird der bistabilen Kippstufe 51 an ihrem Triggereingang ein Signal L_T zugeführt. Darunter ist allgemein ein Triggersignal zu verstehen, also ein Signal, das es der bistabilen Kippstufe 53 ermöglicht, den Zustand ihres Ausgangssignals am Ausgang OUT gemäß dem momentan anliegenden Eingangssignal am Dateneingang D zu ändern.

Für die Ausführung des nächsten Schrittes können die Eingangssignale L_WN und L_WL vor ihrer Zuführung zu den Eingängen des Logik-Gatters 53 so aufbereitet sein bzw. unverändert von der jeweiligen Feststelleinrichtung empfangen und zu dem Logik-Gatter 53 durchgeleitet werden, dass das Eingangssignal L_WN bei eingeschaltetem Schalter in der ersten Versorgungsleitung den hohen Signalpegel hat und das Eingangssignal L_WL bei ausgeschaltetem Schalter in der zweiten Versorgungsleitung den hohen Signalpegel hat. Ferner ist das Logik-Gatter 53 so ausgestaltet, dass es das Signal mit dem hohen Signalpegel ausgibt, wenn beide Eingangssignale den hohen Signalpegel haben.

Das Triggersignal L_T wird beispielsweise abhängig von dem Ausgangssignal am Ausgang OUT der bistabilen Kippstufe 41 aus Fig. 5 erzeugt. Alternativ oder zusätzlich kann das Triggersignal L_T ausgelöst werden, wenn eine Feststelleinrichtung, die den Schaltzustand zumindest eines der elektrischen Schalter feststellt, ein entsprechendes Signal ausgibt. Somit kann insbesondere der oben in Bezug auf Fig. 5 beschriebene Signalwechsel von niedrigem zu hohem Signalpegel, oder ein Signalwechsel einer anderen Einrichtung, welcher einen entsprechenden Zustandswechsel anzeigt, den möglichen Signalwechsel am Ausgang OUT der bistabilen Kippstufe 51 aus Fig. 6 triggern. Wenn in diesem Moment der hohe Signalpegel am Dateneingang D der bistabilen Kippstufe 51 anliegt, d. h. der Schalter in der ersten Versorgungsleitung eingeschaltet ist und der Schalter in der zweiten Versorgungsleitung ausgeschaltet ist, dann findet der Signalwechsel am Ausgang OUT der bistabilen Kippstufe 51 von dem vorher bestehenden niedrigen Signalpegel auf den hohen Signalpegel statt. Auf diese Weise kann festgestellt werden, dass der Schalter in der ersten Versorgungsleitung inzwischen eingeschaltet worden ist.

Zuvor war die Rede von "nächster Schritt" in dem von der Ablaufsteuerung gesteuerten Prozess. Dies bezog sich auf den nächsten Schritt in der Überprüfung des Zustandes der Schalteranordnung. Erwähnt wurde aber auch, dass zwischenzeitlich der Schalter in der ersten Versorgungsleitung eingeschaltet wurde. Im Gesamtprozess der Steuerung kann dies als nächster Schritt bezeichnet werden. Dann wäre der anhand von Fig. 5 beschriebene Schritt des Prozesses der übernächste Schritt oder noch ein späterer Schritt, wenn noch weitere Schritte zwischendurch ausgeführt werden.

Um den Wechsel des Signalpegels am Ausgang OUT der bistabilen Kippstufe 51 aus Fig. 6 zum richtigen Zeitpunkt zu bewirken, kann das Triggersignal L_T verzögert an Triggereingang T eingehen. Dies wird beispielsweise mit klassischen Schaltungsbauteilen wie elektrischen Widerständen, Kondensatoren und Dioden erreicht. Die Verwendung solcher Schaltungsbauteile zu diesem Zweck ist allgemein bekannt und wird daher hier nicht näher beschrieben. Durch die Verzögerung kann vorher zum Beispiel der elektrische Schalter in der ersten Versorgungsleitung eingeschaltet werden. Der Schaltvorgang benötigt eine entsprechende Zeitspanne, auf die die Verzögerung des Triggersignals L_T eingestellt wird.

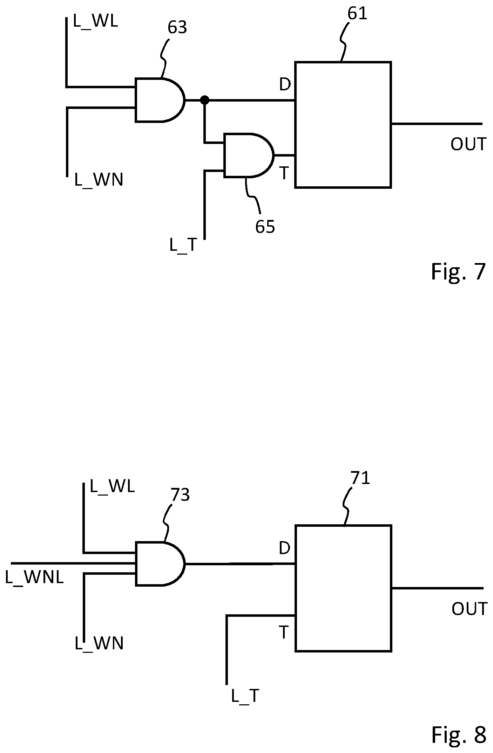

Fig. 7 zeigt eine Modifikation der in Fig. 6 dargestellten Schaltung. Der Ausgang des Logik-Gatters 63 ist mit dem einen Eingang eines zusätzlichen Logik-Gatters 65 verbunden. Der andere Eingang des zusätzlichen Logik-Gatters 65 ist mit der Signalleitung für das Triggersignal L_T verbunden. Der Ausgang des zusätzlichen Logik-Gatters 65 ist mit dem Triggersignaleingang T verbunden.

Damit hängt das Signal am Triggereingang T in der zuvor anhand von Fig. 6 beschriebenen Ausführungsform auch davon ab, dass der bistabilen Kippstufe 61 von der Überwachungseinrichtung der eingeschaltete Zustand des zu überwachenden elektrischen Schalters signalisiert wird. Die bistabile Kippstufe signalisiert daher nur dann, dass der Schritt des Einschaltens des elektrischen Schalters erfolgreich war, wenn der Schalter tatsächlich eingeschaltet wurde. Die dadurch ausschließbaren Fehler wurden bereits beschrieben. Daher wird das Ausgangssignal der bistabilen Kippstufe 61 im Fall dieser Fehler nicht fälschlicherweise auf den hohen Signalpegel gesetzt und wird verhindert, dass der Prozess fälschlicherweise fortgesetzt wird.

Das Prinzip der in Fig. 7 dargestellten Schaltung ist jedoch nicht auf das Überprüfen des Einschaltens des Schalters in der ersten Versorgungsleitung beschränkt. Vielmehr kann jede innerhalb der Hardware-Logik stattfindende Überprüfung eines erwarteten Zustandes in dieser Weise ausgeführt werden. Ferner können die Logik-Gatter zusätzliche Eingänge aufweisen, sodass insbesondere das Signal am Triggereingang T auch noch von den Signalzuständen anderer Signale abhängen kann. Ferner, wie auch bei den zuvor anhand von Fig. 5 und Fig. 6 beschriebenen Schaltungen, können die Signalpegel eingangsseitig der bistabilen Kippstufe im Fall des erwarteten Zustandes anders gewählt werden und/oder kann das Ausgangssignal der bistabilen Kippstufe auf niedrigem Signalpegel signalisieren, dass der erwartete Zustand festgestellt wurde.

Fig. 8 zeigt eine weitere Modifikation der bisher beschriebenen Schaltungen. Diese Modifikation kann auch zusätzlich zu den bereits beschriebenen Modifikationen vorgesehen sein. Die in Fig. 8 dargestellte Modifikation besteht darin, dass das Logik-Gatter 73, dessen Ausgang mit dem Dateneingang D der bistabilen Kippstufe 71 verbunden ist, drei Eingangssignale L_WN, L_WL und L_WNL empfängt. Dabei kann es sich um die (optional mit weiteren Signalen verknüpften und/oder invertierten) Signale bezüglich der Schaltzustände der Schalter handeln, die im Fall der Schaltungsanordnung der Fig. 3 von den Feststelleinrichtungen erzeugt werden.

Insbesondere ermöglicht es die Modifikation der Fig. 8 je nach Ausgestaltung und/oder Vorverarbeitung der Signale bezüglich der Schaltzustände zu prüfen, ob
- alle drei Feststelleinrichtungen übereinstimmend signalisieren, dass beide Schalter ausgeschaltet sind,
- zwei der drei Feststelleinrichtungen übereinstimmend signalisieren, dass ein bestimmter Schalter (entweder der erste Schalter oder der zweite Schalter) eingeschaltet ist.
- alle drei Feststelleinrichtungen übereinstimmend signalisieren, dass beide Schalter eingeschaltet sind.

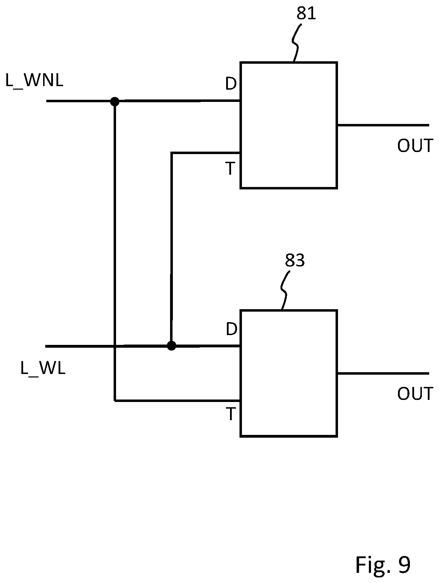

Vorzugsweise jedoch wird insbesondere die Prüfung, ob die Feststelleinrichtungen übereinstimmend signalisieren, dass ein Schalter oder beide Schalter eingeschaltet sind, nicht oder nicht nur mit einer Schaltung wie in Fig. 8 dargestellt durchgeführt. Bevorzugt wird vielmehr eine Schaltung, die dem in Fig. 9 dargestellten Schaltungsprinzip entspricht. Dabei ist die in Fig. 9 dargestellte Schaltung vereinfacht dargestellt. Insbesondere sind die Logik-Gatter weggelassen und als Hardware-Logikelemente lediglich zwei bistabile Kippstufen 81, 83 dargestellt.

Das Schaltungsprinzip besteht darin, das Eingangssignal für den Dateneingang der einen bistabilen Kippstufe als Eingangssignal für den Triggereingang der anderen bistabilen Kippstufe zu verwenden und umgekehrt. Das eine Eingangssignal wird daher über eine Signalleitung dem Dateneingang D der einen bistabilen Kippstufe und dem Triggereingang T der anderen bistabilen Kippstufe zugeführt. Wie erwähnt können dabei noch zusätzliche Logik-Schaltelemente verwendet werden, wie beispielsweise Elemente zur Invertierung eines Signals. Ferner kann insbesondere eines der beiden Eingangssignale das Ausgangssignal eines Logik-Gatters sein, das zwei primäre Eingangssignale (wie zum Beispiel die Signale von zwei verschiedenen Feststelleinrichtungen der Überwachungseinrichtung) miteinander logisch verknüpft.

In dem konkret dargestellten Ausführungsbeispiel ist das eine Eingangssignal zum Beispiel ein Signal L_WL, das den Schaltzustand des Schalters in der zweiten Versorgungsleitung 3b der Fig. 3 repräsentiert, und das andere Eingangssignal zum Beispiel ein Signal L_WNL, das den Schaltzustand der Schalter in der ersten und der zweiten Versorgungsleitung 3a, 3b der Fig. 3 repräsentiert. Alternativ kann zum Beispiel das eine Eingangssignal L_WL bei einer anderen Ausführungsform ersetzt werden durch die Verknüpfung der Signale, die jeweils den Schaltzustand eines der beiden Schalter repräsentieren.

Der Wechsel des Signalpegels eines der Signale triggert den möglichen Wechsel des Ausgangssignals der jeweiligen bistabilen Kippstufe. Dieses Schaltungsprinzip der Fig. 9 ermöglicht es fehlerfrei, die redundanten Informationen der verschiedenen Feststelleinrichtungen auszuwerten. Redundante Informationen in diesem Sinne liegen insbesondere vor, wenn wie im Fall der Fig. 3 sowohl für zumindest einen elektrischen Schalter eine Feststelleinrichtung vorgesehen ist, die den Schaltzustand allein dieses Schalters signalisiert, und außerdem eine Feststelleinrichtung vorgesehen ist, die den gemeinsamen eingeschalteten Zustand von zwei Schaltern signalisieren kann.

Vorzugsweise wird außerdem noch eine zeitliche Toleranz zwischen dem Vorliegen der beiden Eingangssignale (zum Beispiel der Signale L_WL, L_WNL) erlaubt. Dies kann dadurch erreicht werden, dass das dem jeweiligen Triggereingang T zuzuführende Signal am Triggereingang T verzögert den Signalpegel-Wechsel bewirkt, wie oben erwähnt beispielsweise unter Verwendung von diskreten Schaltungsbauelementen wie zumindest einem elektrischen Widerstand und einem Kondensator, sowie zumindest einer Diode zum Abbau der elektrischen Spannung des aufgeladenen Kondensators. Der Signalpegel-Wechsel des Eingangssignals bewirkt somit zunächst die Aufladung des Kondensators, welcher dann im Laufe der Zeit wieder entladen wird. Ab einem Zeitpunkt während des Entladeprozesses entsteht dann der Signalpegel-Wechsel am Triggereingang T.

## Patentansprüche

1. Laborgerät (1), nämlich Zentrifuge, mit entflammbarem Kältemittel, wobei das Laborgerät (1) aufweist:
- einen elektrischen Anschluss (3) zur Versorgung des Laborgeräts (1) mit elektrischer Energie, wobei das Laborgerät (1) für seinen Betrieb über den Anschluss (3) an zumindest zwei unterschiedliche elektrische Potenziale eines elektrischen Wechselstrom-Versorgungsnetzes anschließbar ist,
- eine elektrische Schalteranordnung (5) mit einem ersten elektrischen Schalter zur elektrischen Trennung von einem ersten der zumindest zwei unterschiedlichen elektrischen Potenziale und mit einem zweiten elektrischen Schalter zur elektrischen Trennung von einem zweiten der zumindest zwei unterschiedlichen elektrischen Potenziale,
- eine Ablaufsteuerung (8), die ausgestaltet ist, den ersten elektrischen Schalter (SW_L) und den zweiten elektrischen Schalter (SW_N) einzuschalten,
- eine Überwachungseinrichtung zur Überwachung der elektrischen Schalteranordnung (5), wobei die Überwachungseinrichtung über einen ersten Kontakt geräteseitig mit dem ersten elektrischen Schalter (SW_L) und über einen zweiten Kontakt netzseitig mit einem anderen elektrischen Potenzial als dem ersten elektrischen Potenzial verbunden ist,
wobei die Überwachungseinrichtung ausgestaltet ist, bei Anliegen einer elektrischen Betriebsspannung zwischen dem ersten Kontakt und dem zweiten Kontakt einen eingeschalteten Zustand des ersten elektrischen Schalters (SW_L) festzustellen und diesen Zustand der Ablaufsteuerung (8) zu signalisieren,
wobei die Ablaufsteuerung (8) ausgestaltet ist,
- wenn erwartet wird, dass der erste elektrische Schalter (SW_L) ausgeschaltet ist, ihr jedoch von der Überwachungseinrichtung der eingeschaltete Zustand des ersten elektrischen Schalters (SW_L) signalisiert wird, oder
- wenn erwartet wird, dass der erste elektrische Schalter (SW_L) eingeschaltet ist, ihr jedoch von der Überwachungseinrichtung der ausgeschaltete Zustand des ersten elektrischen Schalters (SW_L) signalisiert wird
einen Betrieb des Laborgeräts (1) zu sperren.

2. Laborgerät nach Anspruch 1, wobei der erste und der zweite elektrische Schalter unabhängig voneinander einschaltbar sind und wobei die Ablaufsteuerung (8) ausgestaltet ist, bei Beginn eines Betriebes des Laborgeräts (1) den ersten elektrischen Schalter und den zweiten elektrischen Schalter nacheinander einzuschalten.

3. Laborgerät nach Anspruch 1 oder 2, wobei die Überwachungseinrichtung über einen dritten Kontakt geräteseitig mit dem zweiten elektrischen Schalter und über einen vierten Kontakt netzseitig mit einem anderen elektrischen Potenzial als dem zweiten elektrischen Potenzial verbunden ist,
wobei die Überwachungseinrichtung ausgestaltet ist, bei Anliegen einer elektrischen Betriebsspannung zwischen dem dritten Kontakt und dem vierten Kontakt einen eingeschalteten Zustand des zweiten elektrischen Schalters festzustellen und diesen Zustand der Ablaufsteuerung (8) zu signalisieren,
wobei die Ablaufsteuerung (8) ausgestaltet ist,
- wenn erwartet wird, dass der zweite elektrische Schalter ausgeschaltet ist, ihr jedoch von der Überwachungseinrichtung der eingeschaltete Zustand des ersten elektrischen Schalters signalisiert wird, oder
- wenn erwartet wird, dass der zweite elektrische Schalter eingeschaltet ist, ihr jedoch von der Überwachungseinrichtung der ausgeschaltete Zustand des ersten elektrischen Schalters (SW_L) signalisiert wird,
einen Betrieb des Laborgeräts (1) zu sperren.

4. Laborgerät nach einem der Ansprüche 1 bis 3, wobei die Ablaufsteuerung (8) ausgestaltet ist,
- einen Prozess zum Einschalten des ersten elektrischen Schalters (SW_L) zu starten, wenn ihr von der Überwachungseinrichtung ein erster vorgegebener Zustand der elektrischen Schalteranordnung (5) signalisiert wird, zu dem es gehört, dass der erste elektrische Schalter ausgeschaltet ist,
- anschließend zu prüfen, ob ihr von der Überwachungseinrichtung der eingeschaltete Zustand des ersten elektrischen Schalters (SW_L) signalisiert wird, und
- den Betrieb des Laborgeräts (1) zu sperren oder einen von ihr zu steuernden Prozess zu stoppen, wenn ihr von der Überwachungseinrichtung der eingeschaltete Zustand des ersten elektrischen Schalters (SW_L) nicht signalisiert wird.

5. Laborgerät nach einem der Ansprüche 1 bis 4, wobei
- die Überwachungseinrichtung eine erste Feststelleinrichtung (W_L, W_N) aufweist, die ausgestaltet ist, bei Anliegen der elektrischen Betriebsspannung zwischen dem ersten Kontakt und dem zweiten Kontakt den eingeschalteten Zustand des ersten elektrischen Schalters (SW_L, SW_N) festzustellen und diesen Zustand der Ablaufsteuerung (8) zu signalisieren,
- die Überwachungseinrichtung über einen fünften Kontakt geräteseitig mit dem ersten elektrischen Schalter (SW_L, SW_N) und über einen sechsten Kontakt geräteseitig mit dem zweiten elektrischen Schalter verbunden ist,
- die Überwachungseinrichtung eine dritte Feststelleinrichtung (W_LN) aufweist, die ausgestaltet ist, bei Anliegen der elektrischen Betriebsspannung zwischen dem fünften Kontakt und dem sechsten Kontakt einen eingeschalteten Zustand des ersten elektrischen Schalters (SW_L, SW_N) und des zweiten elektrischen Schalters festzustellen und diesen Zustand der Ablaufsteuerung (8) zu signalisieren, und
- die Ablaufsteuerung (8) ausgestaltet ist, den Betrieb des Laborgeräts (1) zu sperren oder einen von ihr gesteuerten Prozess zu stoppen, wenn ihr nach einem Einschalten des ersten elektrischen Schalters (SW_L, SW_N) und des zweiten elektrischen Schalters nicht sowohl von der ersten Feststelleinrichtung als auch von der dritten Feststelleinrichtung der jeweilige eingeschaltete Zustand signalisiert wird.

6. Laborgerät nach einem der Ansprüche 1 bis 5, wobei die Ablaufsteuerung (8) eine Testeinrichtung mit einer Simulationseinrichtung aufweist, die ausgestaltet ist, bei aktivierter Simulationseinrichtung für einen Steuerungsprozess der Ablaufsteuerung (8), der zum Einschalten des ersten elektrischen Schalters (SW_L) auszuführen ist, zu simulieren, dass der erste elektrische Schalter nicht eingeschaltet wird,
wobei die Testeinrichtung ausgestaltet ist, bei aktivierter Simulationseinrichtung zu prüfen, ob die Ablaufsteuerung (8) nach einem Durchlauf des Steuerungsprozesses einen Betrieb des Laborgeräts (1) freigibt, und
wobei die Testeinrichtung einen Fehler der Ablaufsteuerung (8) signalisiert, wenn die Ablaufsteuerung (8) bei aktivierter Simulationseinrichtung den Betrieb des Laborgeräts (1) freigibt.

7. Laborgerät nach einem der Ansprüche 1 bis 6, wobei die Ablaufsteuerung (8) eine elektronische Schaltung mit einer bistabilen Kippstufe aufweist, wobei die bistabile Kippstufe eingangsseitig mit einer ersten Signalleitung verbunden ist, über die der bistabilen Kippstufe von der Überwachungseinrichtung signalisiert wird, dass der erste elektrische Schalter eingeschaltet ist, und wobei die bistabile Kippstufe ausgangsseitig mit einer zweiten Signalleitung verbunden ist, über die die bistabile Kippstufe abhängig von einem über die erste Signalleitung übertragenen Signal und abhängig von einem weiteren Signal signalisiert, dass der Einschaltprozesses zum Einschalten des Laborgeräts (1) von der Ablaufsteuerung (8) fortgesetzt werden kann oder dass der Einschaltprozesses erfolgreich war.

8. Laborgerät nach Anspruch 7, wobei das weitere Signal auch davon abhängt, dass der bistabilen Kippstufe von der Überwachungseinrichtung der eingeschaltete Zustand des ersten elektrischen Schalters (SW_L) signalisiert wird.

9. Verfahren zum Betreiben eines Laborgeräts (1), nämlich einer Zentrifuge, mit entflammbarem Kältemittel, wobei das Laborgerät (1) aufweist:
- einen elektrischen Anschluss (3) zur Versorgung des Laborgeräts (1) mit elektrischer Energie, wobei das Laborgerät (1) für seinen Betrieb über den Anschluss (3) an zumindest zwei unterschiedliche elektrische Potenziale eines elektrischen Wechselstrom-Versorgungsnetzes anschließbar ist,
- eine elektrische Schalteranordnung (5) mit einem ersten elektrischen Schalter zur elektrischen Trennung von einem ersten der zumindest zwei unterschiedlichen elektrischen Potenziale und mit einem zweiten elektrischen Schalter zur elektrischen Trennung von einem zweiten der zumindest zwei unterschiedlichen elektrischen Potenziale,
- eine Ablaufsteuerung (8), die ausgestaltet ist, den ersten elektrischen Schalter und den zweiten elektrischen Schalter einzuschalten,
- eine Überwachungseinrichtung zur Überwachung der elektrischen Schalteranordnung (5), wobei die Überwachungseinrichtung über einen ersten Kontakt geräteseitig mit dem ersten elektrischen Schalter und über einen zweiten Kontakt netzseitig mit einem anderen elektrischen Potenzial als dem ersten elektrischen Potenzial verbunden ist,
wobei die Überwachungseinrichtung bei Anliegen einer elektrischen Betriebsspannung zwischen dem ersten Kontakt und dem zweiten Kontakt einen eingeschalteten Zustand des ersten elektrischen Schalters (SW_L) feststellt und diesen Zustand der Ablaufsteuerung (8) signalisiert,
und wobei die Ablaufsteuerung (8),
- wenn erwartet wird, dass der erste elektrische Schalter ausgeschaltet ist, ihr jedoch von der Überwachungseinrichtung der eingeschaltete Zustand des ersten elektrischen Schalters (SW_L) signalisiert wird, oder
- wenn erwartet wird, dass der erste elektrische Schalter eingeschaltet ist, ihr jedoch von der Überwachungseinrichtung der ausgeschaltete Zustand des ersten elektrischen Schalters (SW_L) signalisiert wird,
einen Betrieb des Laborgeräts (1) sperrt.

10. Verfahren nach Anspruch 9, wobei der erste und der zweite elektrische Schalter unabhängig voneinander einschaltbar sind und wobei die Ablaufsteuerung (8) bei Beginn eines Betriebes des Laborgeräts (1) den ersten elektrischen Schalter und den zweiten elektrischen Schalter nacheinander einschaltet.

11. Verfahren nach Anspruch 9 oder 10, wobei die Überwachungseinrichtung über einen dritten Kontakt geräteseitig mit dem zweiten elektrischen Schalter und über einen vierten Kontakt netzseitig mit einem anderen elektrischen Potenzial als dem zweiten elektrischen Potenzial verbunden ist,
wobei die Überwachungseinrichtung bei Anliegen einer elektrischen Betriebsspannung zwischen dem dritten Kontakt und dem vierten Kontakt einen eingeschalteten Zustand des zweiten elektrischen Schalters feststellt und diesen Zustand der Ablaufsteuerung (8) signalisiert,
wobei die Ablaufsteuerung (8),
- wenn erwartet wird, dass der zweite elektrische Schalter ausgeschaltet ist, ihr jedoch von der Überwachungseinrichtung der eingeschaltete Zustand des ersten elektrischen Schalters (SW_L) signalisiert wird, oder
- wenn erwartet wird, dass der zweite elektrische Schalter eingeschaltet ist, ihr jedoch von der Überwachungseinrichtung der ausgeschaltete Zustand des ersten elektrischen Schalters (SW_L) signalisiert wird,
einen Betrieb des Laborgeräts (1) sperrt.

12. Verfahren nach einem der Ansprüche 9 bis 11, wobei die Ablaufsteuerung (8)
- einen Prozess zum Einschalten des ersten elektrischen Schalters (SW_L) startet, wenn ihr von der Überwachungseinrichtung ein erster vorgegebener Zustand der elektrischen Schalteranordnung (5) signalisiert wird, zu dem es gehört, dass der erste elektrische Schalter ausgeschaltet ist,
- anschließend prüft, ob ihr von der Überwachungseinrichtung der eingeschaltete Zustand des ersten elektrischen Schalters (SW_L) signalisiert wird, und
- den Betrieb des Laborgeräts (1) sperrt oder einen von ihr zu steuernden Prozess stoppt, wenn ihr von der Überwachungseinrichtung der eingeschaltete Zustand des ersten elektrischen Schalters (SW_L) nicht signalisiert wird.

13. Verfahren nach einem der Ansprüche 9 bis 12, wobei
- die Überwachungseinrichtung eine erste Feststelleinrichtung (W_L) aufweist, die bei Anliegen der elektrischen Betriebsspannung zwischen dem ersten Kontakt und dem zweiten Kontakt den eingeschalteten Zustand des ersten elektrischen Schalters (SW_L) feststellt und diesen Zustand der Ablaufsteuerung (8) signalisiert,
- die Überwachungseinrichtung über einen fünften Kontakt geräteseitig mit dem ersten elektrischen Schalter und über einen sechsten Kontakt geräteseitig mit dem zweiten elektrischen Schalter verbunden ist,
- die Überwachungseinrichtung eine dritte Feststelleinrichtung (W_LN) aufweist, die bei Anliegen der elektrischen Betriebsspannung zwischen dem fünften Kontakt und dem sechsten Kontakt einen eingeschalteten Zustand des ersten elektrischen Schalters (SW_L) und des zweiten elektrischen Schalters feststellt und diesen Zustand der Ablaufsteuerung (8) signalisiert, und
- die Ablaufsteuerung (8) den Betrieb des Laborgeräts (1) sperrt oder einen von ihr zu steuernden Prozess stoppt, wenn ihr nach einem Einschalten des ersten elektrischen Schalters (SW_L) und des zweiten elektrischen Schalters nicht sowohl von der ersten Feststelleinrichtung als auch von der dritten Feststelleinrichtung der jeweilige eingeschaltete Zustand signalisiert wird.

14. Verfahren nach einem der Ansprüche 9 bis 13, wobei die Ablaufsteuerung (8) eine Testeinrichtung mit einer Simulationseinrichtung aufweist, die bei aktivierter Simulationseinrichtung für einen Steuerungsprozess der Ablaufsteuerung (8), der zum Einschalten des ersten elektrischen Schalters (SW_L) auszuführen ist, simuliert, dass der erste elektrische Schalter (SW_L) nicht eingeschaltet wird,
wobei die Testeinrichtung bei aktivierter Simulationseinrichtung prüft, ob die Ablaufsteuerung (8) nach einem Durchlauf des Steuerungsprozesses einen Betrieb des Laborgeräts (1) freigibt, und
wobei die Testeinrichtung einen Fehler der Ablaufsteuerung (8) signalisiert, wenn die Ablaufsteuerung (8) bei aktivierter Simulationseinrichtung den Betrieb des Laborgeräts (1) freigibt.

15. Verfahren zum Herstellen eines Laborgeräts (1), nämlich einer Zentrifuge, mit entflammbarem Kältemittel, wobei vorgesehen wird:
- ein elektrischer Anschluss (3) zur Versorgung des Laborgeräts (1) mit elektrischer Energie, wobei das Laborgerät (1) für seinen Betrieb über den Anschluss (3) an zumindest zwei unterschiedliche elektrische Potenziale eines elektrischen Wechselstrom-Versorgungsnetzes anschließbar ist,
- eine elektrische Schalteranordnung (5) mit einem ersten elektrischen Schalter zur elektrischen Trennung von einem ersten der zumindest zwei unterschiedlichen elektrischen Potenziale und mit einem zweiten elektrischen Schalter zur elektrischen Trennung von einem zweiten der zumindest zwei unterschiedlichen elektrischen Potenziale,
- eine Ablaufsteuerung (8), die ausgestaltet ist, den ersten elektrischen Schalter und den zweiten elektrischen Schalter einzuschalten,
- eine Überwachungseinrichtung zur Überwachung der elektrischen Schalteranordnung (5), wobei die Überwachungseinrichtung über einen ersten Kontakt geräteseitig mit dem ersten elektrischen Schalter und über einen zweiten Kontakt netzseitig mit einem anderen elektrischen Potenzial als dem ersten elektrischen Potenzial verbunden ist,
wobei die Überwachungseinrichtung ausgestaltet wird, bei Anliegen einer elektrischen Betriebsspannung zwischen dem ersten Kontakt und dem zweiten Kontakt einen eingeschalteten Zustand des ersten elektrischen Schalters (SW_L) festzustellen und diesen Zustand der Ablaufsteuerung (8) zu signalisieren,
wobei die Ablaufsteuerung (8) so ausgestaltet wird, dass sie
- wenn erwartet wird, dass der erste elektrische Schalter ausgeschaltet ist, ihr jedoch von der Überwachungseinrichtung der eingeschaltete Zustand des ersten elektrischen Schalters (SW_L) signalisiert wird, oder
- wenn erwartet wird, dass der erste elektrische Schalter eingeschaltet ist, ihr jedoch von der Überwachungseinrichtung der ausgeschaltete Zustand des ersten elektrischen Schalters (SW_L) signalisiert wird
einen Betrieb des Laborgeräts (1) sperrt.

## Claims

1. Laboratory device (1), namely a centrifuge, with flammable refrigerant, wherein the laboratory device (1) comprising:
an electrical connection (3) for supplying the laboratory device (1) with electrical energy, wherein the laboratory device (1) can be connected via the connection (3) to at least two different electrical potentials of an electrical alternating current supply network for its operation,
an electrical switch arrangement (5) with a first electrical switch for electrical separation from a first of the at least two different electrical potentials and with a second electrical switch for electrical separation from a second of the at least two different electrical potentials,
a sequence controller (8) designed to switch on the first electrical switch (SW_L) and the second electrical switch (SW_N),
a monitoring device for monitoring the electrical switch arrangement (5), wherein the monitoring device is connected via a first contact on the device side to the first electrical switch (SW_L) and via a second contact on the mains side to an electrical potential other than the first electrical potential,
wherein the monitoring device is designed to detect an activated state of the first electrical switch (SW_L) when an electrical operating voltage is applied between the first contact and the second contact and to signal this state to the sequence controller (8),
wherein the sequence controller (8) is designed
if it is expected that the first electrical switch (SW_L) is switched off, but the monitoring device signals the switched-on state of the first electrical switch (SW_L) to it, or
if it is expected that the first electrical switch (SW_L) is switched on, but the monitoring device signals to it that the first electrical switch (SW_L) is switched off
to block operation of the laboratory device (1).

2. Laboratory device according to claim 1, wherein the first and second electrical switches can be switched on independently of each other and wherein the sequence control (8) is designed
to switch on the first electrical switch and the second electrical switch one after the other at the start of operation of the laboratory device (1).

3. Laboratory device according to claim 1 or 2, wherein the monitoring device is connected via a third contact on the device side to the second electrical switch and via a fourth contact on the mains side to an electrical potential other than the second electrical potential,
wherein the monitoring device is designed to detect an activated state of the second electrical switch when an electrical operating voltage is applied between the third contact and the fourth contact and to signal this state to the sequence controller (8),
wherein the sequence controller (8) is designed
if it is expected that the second electrical switch is switched off, but the monitoring device signals the switched-on state of the first electrical switch to it, or
if it is expected that the second electrical switch is switched on, but the monitoring device signals to it that the first electrical switch (SW_L) is switched off,
to block operation of the laboratory device (1).

4. Laboratory device according to one of claims 1 to 3, wherein the sequence controller (8) is designed
- start a process for switching on the first electrical switch (SW_L) when a first predetermined state of the electrical switch arrangement (5) is signaled to it by the monitoring device, which state includes the first electrical switch being switched off,
- then to check whether the monitoring device signals the switched-on state of the first electrical switch (SW_L) to it, and
- to block the operation of the laboratory device (1) or to stop a process controlled by it if the monitoring device does not signal the switched-on state of the first electrical switch (SW_L).

5. Laboratory device according to one of claims 1 to 4, wherein
- the monitoring device has a first detection device (W_L, W_N) which is designed to detect the switched-on state of the first electrical switch (SW_L, SW_N) when the electrical operating voltage is applied between the first contact and the second contact and to signal this state to the sequence controller (8),
- the monitoring device is connected to the first electrical switch (SW_L, SW_N) on the device side via a fifth contact and to the second electrical switch on the device side via a sixth contact,
- the monitoring device has a third detection device (W_LN) which is designed to detect an activated state of the first electrical switch (SW_L, SW_N) and the second electrical switch when the electrical operating voltage is applied between the fifth contact and the sixth contact and to signal this state to the sequence controller (8), and
- the sequence controller (8) is designed to block the operation of the laboratory device (1) or to stop a process controlled by it if, after switching on the first electrical switch (SW_L, SW_N) and the second electrical switch, the respective switched-on state is not signaled to it by both the first locking device and the third locking device.

6. Laboratory device according to one of claims 1 to 5, wherein the sequence controller (8) has a test device with a simulation device which is designed, when the simulation device is activated for a control process of the sequence controller (8) which is to be executed to switch on the first electrical switch (SW_L), to simulate that the first electrical switch is not switched on,
wherein the test device is designed to check, when the simulation device is activated, whether the sequence controller (8) enables operation of the laboratory device (1) after a control process has been run, and
wherein the test device signals an error in the sequence controller (8) if the sequence controller (8) enables operation of the laboratory device (1) when the simulation device is activated.

7. Laboratory device according to one of claims 1 to 6, wherein the sequence controller (8) has an electronic circuit with a bistable flip-flop, wherein the bistable flip-flop is connected on the input side to a first signal line via which the monitoring device signals to the bistable flip-flop that the first electrical switch is switched on, and wherein the bistable flip-flop is connected on the output side to a second signal line, via which the bistable flip-flop signals, depending on a signal transmitted via the first signal line and depending on a further signal, that the switch-on process for switching on the laboratory device (1) can be continued by the sequence controller (8) or that the switch-on process was successful.

8. Laboratory device according to claim 7, wherein the further signal also depends on the bistable flip-flop being signaled by the monitoring device that the first electrical switch (SW_L) is in the switched-on state.

9. Method for operating a laboratory device (1), namely a centrifuge, with flammable refrigerant, wherein the laboratory device (1) comprises:
an electrical connection (3) for supplying the laboratory device (1) with electrical energy, wherein the laboratory device (1) can be connected via the connection (3) to at least two different electrical potentials of an electrical alternating current supply network for its operation,
an electrical switch arrangement (5) with a first electrical switch for electrical separation from a first of the at least two different electrical potentials and with a second electrical switch for electrical separation from a second of the at least two different electrical potentials,
a sequence controller (8) designed to switch on the first electrical switch and the second electrical switch,
a monitoring device for monitoring the electrical switch arrangement (5), wherein the monitoring device is connected via a first contact on the device side to the first electrical switch and via a second contact on the mains side to an electrical potential other than the first electrical potential,
wherein the monitoring device detects an activated state of the first electrical switch (SW_L) when an electrical operating voltage is applied between the first contact and the second contact and signals this state to the sequence controller (8),
and wherein the sequence controller (8),
if it is expected that the first electrical switch is switched off, but the monitoring device signals to it that the first electrical switch (SW_L) is switched on, or
if it is expected that the first electrical switch is switched on, but the monitoring device signals to it that the first electrical switch (SW_L) is switched off,
blocks operation of the laboratory device (1).

10. Method according to claim 9, wherein the first and second electrical switches can be switched on independently of each other and wherein the sequence controller (8) switches on the first electrical switch and the second electrical switch one after the other at the start of operation of the laboratory device (1).

11. Method according to claim 9 or 10, wherein the monitoring device is connected via a third contact on the device side to the second electrical switch and via a fourth contact on the mains side to an electrical potential other than the second electrical potential,
wherein the monitoring device detects an activated state of the second electrical switch when an electrical operating voltage is applied between the third contact and the fourth contact and signals this state to the sequence controller (8),
wherein the sequence controller (8),
if it is expected that the second electrical switch is switched off, but the monitoring device signals the switched-on state of the first electrical switch (SW_L) to it, or
if it is expected that the second electrical switch is switched on, but the monitoring device signals to it that the first electrical switch (SW_L) is switched off,
blocks operation of the laboratory device (1).

12. Method according to one of claims 9 to 11, wherein the sequence controller (8)
- starts a process for switching on the first electrical switch (SW_L) when the monitoring device signals a first predetermined state of the electrical switch arrangement (5) is signaled to it, which includes the first electrical switch being switched off,
- then checks whether the monitoring device signals the switched-on state of the first electrical switch (SW_L) to it, and
- blocks the operation of the laboratory device (1) or stops a process controlled by it if the monitoring device does not signal that the first electrical switch (SW_L) is switched on.

13. Method according to one of claims 9 to 12, wherein
- the monitoring device has a first detection device (W_L) which, when the electrical operating voltage is applied between the first contact and the second contact, detects the switched-on state of the first electrical switch (SW_L) and signals this state to the sequence controller (8),
- the monitoring device is connected to the first electrical switch via a fifth contact on the device side and to the second electrical switch via a sixth contact on the device side,
- the monitoring device has a third locking device (W_LN) which, when the operating voltage is applied between the fifth contact and the sixth contact, detects an activated state of the first electrical switch (SW_L) and the second electrical switch and signals this state to the sequence controller (8), and
- the sequence controller (8) blocks the operation of the laboratory device (1) or stops a process to be controlled by it if, after switching on the first electrical switch (SW_L) and the second electrical switch, the respective switched-on state is not signaled to it by both the first locking device and the third locking device.

14. Method according to one of claims 9 to 13, wherein the sequence controller (8) has a test device with a simulation device which, when the simulation device is activated for a control process of the sequence controller (8) which is to be carried out to switch on the first electrical switch (SW_L), simulates that the first electrical switch (SW_L) is not switched on,
wherein the test device checks, when the simulation device is activated, whether the sequence controller (8) enables operation of the laboratory device (1) after a run of the control process, and
wherein the test device signals an error in the sequence controller (8) if the sequence controller (8) enables operation of the laboratory device (1) when the simulation device is activated.

15. Method for manufacturing a laboratory device (1), namely a centrifuge, with flammable refrigerant, wherein the following is provided:
an electrical connection (3) for supplying the laboratory device (1) with electrical energy, wherein the laboratory device (1) can be connected via the connection (3) to at least two different electrical potentials of an electrical alternating current supply network for its operation,
an electrical switch arrangement (5) with a first electrical switch for electrical separation from a first of the at least two different electrical potentials and with a second electrical switch for electrical separation from a second of the at least two different electrical potentials,
a sequence controller (8) designed to switch on the first electrical switch and the second electrical switch,
a monitoring device for monitoring the electrical switch arrangement (5), wherein the monitoring device is connected via a first contact on the device side to the first electrical switch and via a second contact on the network side to an electrical potential other than the first electrical potential,
wherein the monitoring device is designed to detect an activated state of the first electrical switch (SW_L) when an electrical operating voltage is applied between the first contact and the second contact and to signal this state to the sequence controller (8),
wherein the sequence controller (8) is designed such that
if it is expected that the first electrical switch is switched off, but the monitoring device signals the switched-on state of the first electrical switch (SW_L) to it, or
if it is expected that the first electrical switch is switched on, but the monitoring device signals to it that the first electrical switch (SW_L) is switched off
it blocks operation of the laboratory device (1).

## Revendications

1. Appareil de laboratoire (1), à savoir une centrifugeuse, avec un réfrigérant inflammable, l'appareil de laboratoire (1) comprenant :
une connexion électrique (3) pour alimenter l'appareil de laboratoire (1) en énergie électrique, l'appareil de laboratoire (1) pouvant être raccordé, pour son fonctionnement, via la connexion (3) à au moins deux potentiels électriques différents d'un réseau d'alimentation électrique à courant alternatif,
un dispositif de commutation électrique (5) avec un premier interrupteur électrique pour la séparation électrique d'un premier des au moins deux potentiels électriques différents et avec un deuxième interrupteur électrique pour la séparation électrique d'un deuxième des au moins deux potentiels électriques différents,
une commande séquentielle (8) qui est conçue pour activer le premier interrupteur électrique (SW_L) et le deuxième interrupteur électrique (SW_N),
un dispositif de surveillance pour surveiller le dispositif de commutation électrique (5), le dispositif de surveillance étant relié au premier commutateur électrique (SW_L) via un premier contact côté appareil et à un potentiel électrique différent du premier potentiel électrique via un deuxième contact côté réseau,
le dispositif de surveillance étant conçu pour détecter, lorsqu'une tension de service électrique est appliquée entre le premier contact et le deuxième contact, un état activé du premier interrupteur électrique (SW_L) et pour signaler cet état à la commande séquentielle (8),
la commande séquentielle (8) étant conçue de telle sorte que
lorsqu'il est prévu que le premier interrupteur électrique (SW_L) soit désactivé, mais que le dispositif de surveillance lui signale l'état activé du premier interrupteur électrique (SW_L), ou
lorsqu'il est prévu que le premier interrupteur électrique (SW_L) soit activé, mais que le dispositif de surveillance lui signale l'état désactivé du premier interrupteur électrique (SW_L)
bloquer le fonctionnement de l'appareil de laboratoire (1).

2. Appareil de laboratoire selon la revendication 1, dans lequel le premier et le deuxième interrupteurs électriques peuvent être activés indépendamment l'un de l'autre et dans lequel la commande séquentielle (8) est conçue
est conçue pour activer successivement le premier interrupteur électrique et le deuxième interrupteur électrique au début du fonctionnement de l'appareil de laboratoire (1).

3. Appareil de laboratoire selon la revendication 1 ou 2, dans lequel le dispositif de surveillance est relié au deuxième interrupteur électrique côté appareil par un troisième contact et à un potentiel électrique différent du deuxième potentiel électrique côté réseau par un quatrième contact,
le dispositif de surveillance étant conçu pour détecter, lorsqu'une tension électrique de service est appliquée entre le troisième contact et le quatrième contact, un état activé du deuxième interrupteur électrique et pour signaler cet état à la commande séquentielle (8),
la commande séquentielle (8) étant conçue de telle sorte que
lorsqu'il est prévu que le deuxième interrupteur électrique soit désactivé, mais que le dispositif de surveillance lui signale l'état activé du premier interrupteur électrique, ou lorsqu'il est prévu que le deuxième interrupteur électrique soit activé, mais que le dispositif de surveillance lui signale l'état désactivé du premier interrupteur électrique (SW_L),
bloquer le fonctionnement de l'appareil de laboratoire (1).

4. Appareil de laboratoire selon l'une des revendications 1 à 3, dans lequel la commande séquentielle (8) est conçue pour
- pour démarrer un processus de mise en marche du premier interrupteur électrique (SW_L) lorsqu'un premier état prédéfini du dispositif à interrupteurs électriques (5) lui est signalé par le dispositif de surveillance, état dans lequel le premier interrupteur électrique est désactivé,
- de vérifier ensuite si le dispositif de surveillance lui signale l'état activé du premier interrupteur électrique (SW_L), et
- bloquer le fonctionnement de l'appareil de laboratoire (1) ou arrêter un processus qu'il commande lorsque le dispositif de surveillance ne lui signale pas l'état activé du premier interrupteur électrique (SW_L).

5. Appareil de laboratoire selon l'une des revendications 1 à 4, dans lequel
- le dispositif de surveillance comporte un premier dispositif de détection (W_L, W_N) qui est conçu pour détecter l'état activé du premier interrupteur électrique (SW_L, SW_N) lorsque la tension électrique de service est appliquée entre le premier contact et le deuxième contact et pour signaler cet état à la commande séquentielle (8),
- le dispositif de surveillance est relié, côté appareil, au premier interrupteur électrique (SW_L, SW_N) par un cinquième contact et au deuxième interrupteur électrique par un sixième contact,
- le dispositif de surveillance comporte un troisième dispositif de détection (W_LN) qui est conçu pour détecter, lorsque la tension électrique de service est appliquée entre le cinquième contact et le sixième contact, un état activé du premier interrupteur électrique (SW_L, SW_N) et du deuxième interrupteur électrique et pour signaler cet état à la commande séquentielle (8), et
- la commande séquentielle (8) est conçue pour bloquer le fonctionnement de l'appareil de laboratoire (1) ou pour arrêter un processus qu'elle commande lorsque, après la mise en marche du premier interrupteur électrique (SW_L, SW_N) et du deuxième interrupteur électrique, l'état activé correspondant ne lui est signalé ni par le premier dispositif de verrouillage ni par le troisième dispositif de verrouillage.

6. Appareil de laboratoire selon l'une des revendications 1 à 5, dans lequel la commande séquentielle (8) comprend un dispositif de test avec un dispositif de simulation qui est conçu pour simuler, lorsque le dispositif de simulation est activé pour un processus de commande de la commande séquentielle (8) qui doit être exécuté pour activer le premier interrupteur électrique (SW_L), de simuler que le premier interrupteur électrique n'est pas activé,
le dispositif de test étant conçu pour vérifier, lorsque le dispositif de simulation est activé, si la commande séquentielle (8) autorise le fonctionnement de l'appareil de laboratoire (1) après un cycle du processus de commande, et
le dispositif de test signalant une erreur de la commande séquentielle (8) lorsque la commande séquentielle (8) autorise le fonctionnement de l'appareil de laboratoire (1) lorsque le dispositif de simulation est activé.

7. Appareil de laboratoire selon l'une des revendications 1 à 6, dans lequel la commande séquentielle (8) comprend un circuit électronique avec un basculeur bistable, le basculeur bistable
est relié côté entrée à une première ligne de signalisation par laquelle le dispositif de surveillance signale à l'étage à bascule bistable que le premier interrupteur électrique est enclenché, et dans lequel l'étage à bascule bistable est relié côté sortie à une deuxième ligne de signalisation, par l'intermédiaire de laquelle l'étage à bascule bistable signale, en fonction d'un signal transmis par la première ligne de signalisation et en fonction d'un autre signal, que le processus de mise en marche de l'appareil de laboratoire (1) peut être poursuivi par le dispositif de commande séquentielle (8) ou que le processus de mise en marche a été couronné de succès.

8. Appareil de laboratoire selon la revendication 7, dans lequel l'autre signal dépend également du fait que l'état activé du premier interrupteur électrique (SW_L) est signalé à l'étage à bascule bistable par le dispositif de surveillance.

9. Procédé pour faire fonctionner un appareil de laboratoire (1), à savoir une centrifugeuse, avec un réfrigérant inflammable, l'appareil de laboratoire (1) comportant :
un raccordement électrique (3) pour alimenter l'appareil de laboratoire (1) en énergie électrique, l'appareil de laboratoire (1) pouvant être raccordé, pour son fonctionnement, via le raccordement (3) à au moins deux potentiels électriques différents d'un réseau d'alimentation électrique à courant alternatif,
un dispositif de commutation électrique (5) avec un premier interrupteur électrique pour la séparation électrique d'un premier des au moins deux potentiels électriques différents et avec un deuxième interrupteur électrique pour la séparation électrique d'un deuxième des au moins deux potentiels électriques différents,
une commande séquentielle (8) qui est conçue pour activer le premier interrupteur électrique et le deuxième interrupteur électrique,
un dispositif de surveillance pour surveiller le dispositif de commutation électrique (5), le dispositif de surveillance étant relié, côté appareil, au premier interrupteur électrique par un premier contact et, côté réseau, à un potentiel électrique différent du premier potentiel électrique par un deuxième contact,
le dispositif de surveillance détectant, lorsqu'une tension de service électrique est appliquée entre le premier contact et le deuxième contact, un état activé du premier interrupteur électrique (SW_L) et signalant cet état à la commande séquentielle (8), et le contrôleur de séquence (8),
lorsqu'il est prévu que le premier interrupteur électrique soit désactivé, mais que le dispositif de surveillance lui signale l'état activé du premier interrupteur électrique (SW_L), ou
lorsqu'il est prévu que le premier interrupteur électrique soit activé, mais que le dispositif de surveillance lui signale l'état désactivé du premier interrupteur électrique (SW_L),
bloque le fonctionnement de l'appareil de laboratoire (1).

10. Procédé selon la revendication 9, dans lequel le premier et le deuxième interrupteurs électriques peuvent être activés indépendamment l'un de l'autre et dans lequel la commande séquentielle (8) active successivement le premier interrupteur électrique et le deuxième interrupteur électrique au début du fonctionnement de l'appareil de laboratoire (1).

11. Procédé selon la revendication 9 ou 10, dans lequel le dispositif de surveillance est relié au deuxième interrupteur électrique côté appareil par un troisième contact et à un potentiel électrique différent du deuxième potentiel électrique côté réseau par un quatrième contact, le dispositif de surveillance détectant, lorsqu'une tension électrique de service est appliquée entre le troisième contact et le quatrième contact, un état activé du deuxième interrupteur électrique et signalant cet état à la commande séquentielle (8),
la commande séquentielle (8),
lorsqu'il est prévu que le deuxième interrupteur électrique soit désactivé, mais que le dispositif de surveillance lui signale l'état activé du premier interrupteur électrique (SW_L), ou
lorsqu'il est prévu que le deuxième interrupteur électrique soit activé, mais que le dispositif de surveillance lui signale que le premier interrupteur électrique (SW_L) est désactivé,
bloque le fonctionnement de l'appareil de laboratoire (1).

12. Procédé selon l'une des revendications 9 à 11, dans lequel la commande séquentielle (8)
- lance un processus pour activer le premier interrupteur électrique (SW_L) lorsque le dispositif de surveillance lui signale un premier état prédéfini de l' dispositif de commutation électrique (5) auquel appartient le fait que le premier interrupteur électrique est désactivé,
- vérifie ensuite si le dispositif de surveillance lui signale l'état activé du premier interrupteur électrique (SW_L), et
- bloque le fonctionnement de l'appareil de laboratoire (1) ou arrête un processus qu'elle doit commander lorsque le dispositif de surveillance ne lui signale pas que le premier interrupteur électrique (SW_L) est en position marche.

13. Procédé selon l'une des revendications 9 à 12, dans lequel
- le dispositif de surveillance comporte un premier dispositif de détection (W_L) qui, lorsque la tension électrique de service est appliquée entre le premier contact et le deuxième contact, détecte l'état activé du premier interrupteur électrique (SW_L) et signale cet état à la commande séquentielle (8),
- le dispositif de surveillance est relié au premier interrupteur électrique côté appareil par un cinquième contact et au deuxième interrupteur électrique côté appareil par un sixième contact,
- le dispositif de surveillance comporte un troisième dispositif de détection (W_LN) qui, lorsque la tension électrique de service est appliquée entre le cinquième contact et le sixième contact, détecte l'état activé du premier interrupteur électrique (SW_L) et du deuxième interrupteur électrique et signale cet état à la commande séquentielle (8), et
- la commande séquentielle (8) bloque le fonctionnement de l'appareil de laboratoire (1) ou arrête un processus qu'elle doit commander lorsque, après la mise en marche du premier interrupteur électrique (SW_L) et du deuxième interrupteur électrique, l'état activé correspondant ne lui est signalé ni par le premier dispositif de verrouillage ni par le troisième dispositif de verrouillage.

14. Procédé selon l'une des revendications 9 à 13, dans lequel la commande séquentielle (8) comporte un dispositif de test avec un dispositif de simulation qui, lorsque le dispositif de simulation est activé pour un processus de commande de la commande séquentielle (8) qui doit être exécuté pour activer le premier interrupteur électrique (SW_L), simule que le premier interrupteur électrique (SW_L) n'est pas activé,
le dispositif de test vérifiant, lorsque le dispositif de simulation est activé, si la commande séquentielle (8) autorise le fonctionnement de l'appareil de laboratoire (1) après un cycle du processus de commande, et
le dispositif de test signalant une erreur du dispositif de commande séquentielle (8) lorsque le dispositif de commande séquentielle (8) autorise le fonctionnement de l'appareil de laboratoire (1) lorsque le dispositif de simulation est activé.

15. Procédé de fabrication d'un appareil de laboratoire (1), à savoir une centrifugeuse, avec un réfrigérant inflammable, dans lequel il est prévu :
un raccordement électrique (3) pour alimenter l'appareil de laboratoire (1) en énergie électrique, l'appareil de laboratoire (1) pouvant être raccordé pour son fonctionnement via le raccordement (3) à au moins deux potentiels électriques différents d'un réseau d'alimentation électrique à courant alternatif,
un dispositif de commutation électrique (5) avec un premier interrupteur électrique pour la séparation électrique d'un premier des au moins deux potentiels électriques différents et avec un deuxième interrupteur électrique pour la séparation électrique d'un deuxième des au moins deux potentiels électriques différents,
une commande séquentielle (8) qui est conçue pour activer le premier interrupteur électrique et le deuxième interrupteur électrique,
un dispositif de surveillance pour surveiller le dispositif de commutation électrique (5), le dispositif de surveillance étant relié au premier interrupteur électrique via un premier contact côté appareil et à un potentiel électrique différent du premier potentiel électrique via un deuxième contact côté réseau,
le dispositif de surveillance étant conçu pour détecter un état activé du premier interrupteur électrique (SW_L) lorsqu'une tension de service électrique est appliquée entre le premier contact et le deuxième contact et pour signaler cet état à la commande séquentielle (8),
la commande séquentielle (8) étant conçue de manière à
lorsqu'il est prévu que le premier interrupteur électrique soit désactivé, mais que le dispositif de surveillance lui signale l'état activé du premier interrupteur électrique (SW_L), ou
lorsqu'il est prévu que le premier interrupteur électrique soit activé, mais que le dispositif de surveillance lui signale l'état désactivé du premier interrupteur électrique (SW_L)
bloque le fonctionnement de l'appareil de laboratoire (1).
